# EUROPEAN PATENT APPLICATION

(11) **EP 4 361 192 A1**
(43) Date of publication of application: **01.05.2024**
(21) Application number: 22828037.6
(22) Date of filing: 31.03.2022
(51) Int. Cl.: C08G 59/20, G03F 7/004, G03F 7/038, G03F 7/075, G03F 7/20, H05K 3/28

(54) **PHOTOSENSITIVE RESIN COMPOSITION, PHOTOSENSITIVE RESIN FILM, PHOTOSENSITIVE DRY FILM, AND PATTERN FORMATION METHOD**

(30) Priority: 22.06.2021 JP 2021102927
(71) Applicant: SHIN-ETSU CHEMICAL CO., LTD., Tokyo 1000005 (JP)
(72) Inventor: MARUYAMA Hitoshi, Annaka-shi, Gunma 379-0224 (JP); HAYASHI Kumiko, Annaka-shi, Gunma 379-0224 (JP)
(74) Representative: Ter Meer Steinmeister & Partner
(86) International application number: PCT/JP2022/016421
(87) International publication number: WO 2022/270118

(57) **Abstract**

Provided is a photosensitive resin composition comprising: (A) a silicone resin having an epoxy group and/or a phenolic hydroxyl group; (B) a photoacid generator represented by formula (B); and (C) a benzotriazole compound.

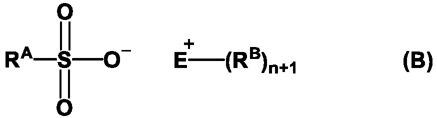

## Description

### TECHNICAL FIELD

The present invention relates to a photosensitive resin composition, a photosensitive resin film, a photosensitive dry film and a patterning process.

### BACKGROUND ART

Photosensitive polyimide compositions, photosensitive epoxy resin compositions, photosensitive silicone compositions and the like have hitherto been used as photosensitive protective films for semiconductor devices and photosensitive dielectric films for multilayer printed boards. Among photosensitive materials employed for the protection of such boards and circuits, a photosensitive silicone composition of particularly outstanding flexibility has been described (Patent Document 1). This photosensitive silicone composition is curable at low temperature and can form a film of excellent reliability, such as moisture-resistant adhesion, but it has a poor chemical resistance to photoresist strippers having a strong dissolving power such as N-methyl-2-pyrrolidone.

One proposed solution is a photosensitive silicone composition based on a silphenylene skeleton-containing silicone polymer (Patent Document 2). This photosensitive silicone composition has an improved chemical resistance to photoresist strippers, but further improvement is desired in the level of scaling achieved by patterning and in the copper electromigration resistance. Also, when this photosensitive silicone composition is prepared as a varnish, the viscosity of the varnish changes over time, affecting control of the film thickness during spin coating onto a wafer and during dry film application. Improvement with regard to these points is also desired.

### PRIOR ART DOCUMENTS

### PATENT DOCUMENTS

Patent Document 1: JP-A 2002-88158
Patent Document 2: JP-A 2008-184571

### SUMMARY OF INVENTION

### TECHNICAL PROBLEM

The present invention was arrived at in light of the above circumstances. An object of this invention is to provide a photosensitive resin composition which has a good storage stability as a varnish or a dry film, enabling fine patterning to be easily carried out with a thick film; which has an excellent copper electromigration resistance and also excellent film properties such as adhesion to substrates, electronic components, semiconductor devices and the like, especially to the base material used in circuit boards; and which can form a resin film (resin layer) of excellent reliability as a protective film for electrical and electronic components and as a substrate bonding film. Further objects of the invention include a photosensitive resin film and a photosensitive dry film obtained with the photosensitive resin composition, and patterning processes that use the photosensitive resin composition, the photosensitive resin film or the photosensitive dry film.

### SOLUTION TO PROBLEM

As a result of intensive investigations, the inventors have discovered that the above objects can be achieved with a photosensitive resin composition that includes a silicone resin having epoxy groups and/or phenolic hydroxyl groups, a photoacid generator having a specific structure and a benzotriazole compound. This discovery ultimately led to the present invention.

Accordingly, the invention provides the following photosensitive resin composition, photosensitive resin film, photosensitive dry film and patterning processes.
1. A photosensitive resin composition which includes:
   (A) an epoxy group and/or phenolic hydroxyl group-containing silicone resin,
   (B) a photoacid generator of formula (B) below 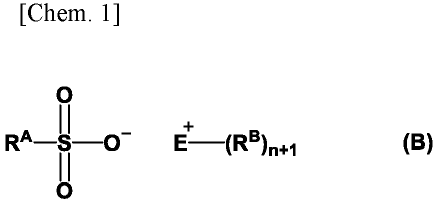 (wherein R^{A} is a hydrocarbyl group of 1 to 12 carbon atoms, some or all of the hydrogen atoms on which may be substituted with fluorine atoms,
      each R^{B} is independently a monovalent organic group and two or more R^{B} groups may be bonded to each other directly or through -O-, -S-, -SO-, -SO₂-, -NH-, -CO-, COO-, -CONH-, a saturated hydrocarbylene group of 1 to 20 carbon atoms or a phenylene group to form a cyclic structure that includes an element E,
      E is an element belonging to Groups 15 to 17 of the periodical table and having a valence n, and
      n is an integer from 1 to 3), and
   (C) a benzotriazole compound.
2. The photosensitive resin composition according to 1 above, wherein the silicone resin (A) is represented by formula (A) below 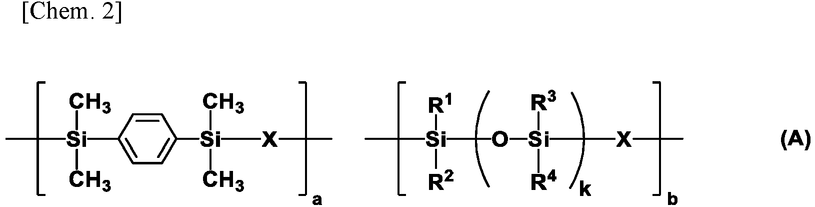 (wherein R¹ to R⁴ are each independently a hydrocarbyl group of 1 to 8 carbon atoms, k is an integer from 1 to 600, a and b are numbers which indicate the compositional ratios (molar ratios) of the respective recurring units and satisfy the conditions 0 < a < 1, 0 < b < 1 and a+b = 1; and X is an epoxy group and/or phenolic hydroxyl group-containing divalent organic group).
3. The photosensitive resin composition according to 2 above, wherein the silicone resin (A) includes recurring units of formulas (a1) to (a4) and (b1) to (b4) below 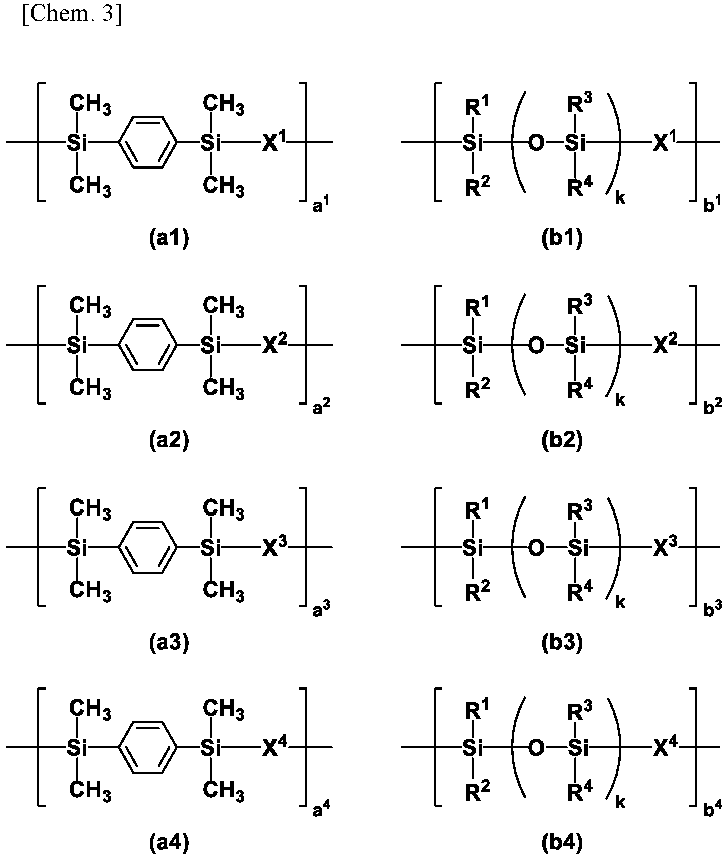 [wherein R¹ to R⁴ are each independently a hydrocarbyl group of 1 to 8 carbon atoms; k is an integer from 1 to 600; a¹ to a⁴ and b¹ to b⁴ are numbers which indicate the compositional ratios (molar ratios) of the respective recurring units and satisfy the conditions 0 ≤ a¹ < 1, 0 ≤ a² < 1, 0 ≤ a³ < 1, 0 ≤ a⁴ < 1, 0 ≤ b¹ < 1, 0 ≤ b² < 1, 0 ≤ b³ < 1, 0 ≤ b⁴ < 1,0 < a¹+a²+a³ < 1,0 < b¹+b²+b³ < 1 and a¹+a²+a³+a⁴+b¹+b²+b³+b⁴ = 1; X¹ is a divalent group of formula (X1) below 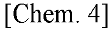 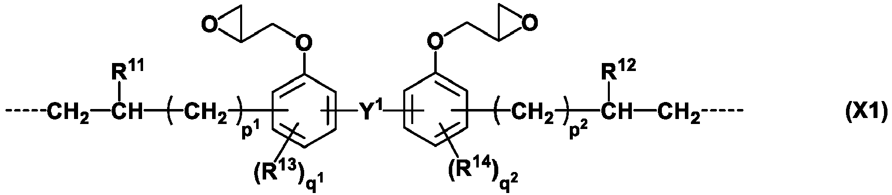 (wherein Y¹ is a single bond, a methylene group, a propane-2,2-diyl group, a 1,1,1,3,3,3-hexafluoropropane-2,2-diyl group or a fluorene-9,9-diyl group; R¹¹ and R¹² are each independently a hydrogen atom or a methyl group; R¹³ and R¹⁴ are each independently a saturated hydrocarbyl group of 1 to 4 carbon atoms or a saturated hydrocarbyloxy group of 1 to 4 carbon atoms; p¹ and p² are each independently an integer from 0 to 7; q¹ and q² are each independently an integer from 0 to 2; and the dashed lines are bonding sites); X² is a divalent group of formula (X2) below 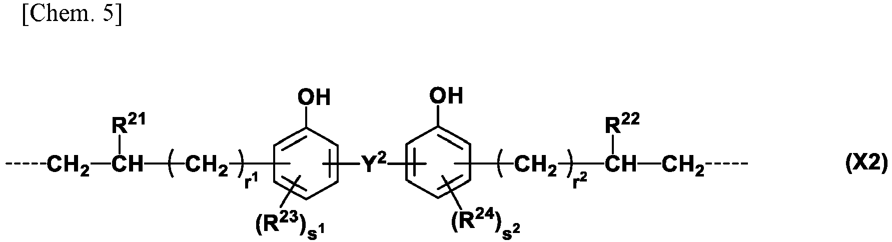 (wherein Y² is a single bond, a methylene group, a propane-2,2-diyl group, a 1,1,1,3,3,3-hexafluoropropane-2,2-diyl group or a fluorene-9,9-diyl group; R²¹ and R²² are each independently a hydrogen atom or a methyl group; R²³ and R²⁴ are each independently a saturated hydrocarbyl group of 1 to 4 carbon atoms or a saturated hydrocarbyloxy group of 1 to 4 carbon atoms; r¹ and r² are each independently an integer from 0 to 7; s¹ and s² are each independently an integer from 0 to 2; and the dashed lines are bonding sites); X³ is a divalent group of formula (X3) below 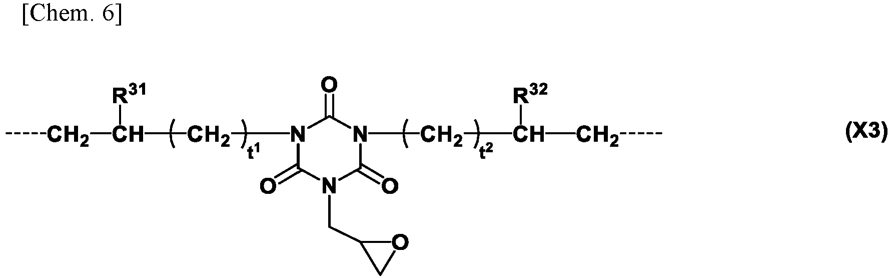 (wherein R³¹ and R³² are each independently a hydrogen atom or a methyl group; t¹ and t² are each independently an integer from 0 to 7; and the dashed lines are bonding sites); and X⁴ is a divalent group of formula (X4) below 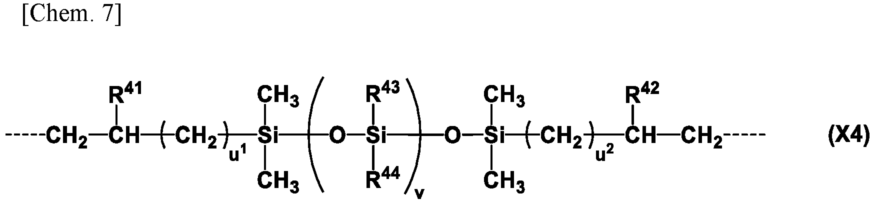 (wherein R⁴¹ and R⁴² are each independently a hydrogen atom or a methyl group; R⁴³ and R⁴⁴ are each independently a hydrocarbyl group of 1 to 8 carbon atoms; u¹ and u² are each independently an integer from 0 to 7; v is an integer from 0 to 600; and the dashed lines are bonding sites)].
4. The photosensitive resin composition according to any of 1 to 3 above, wherein E is a sulfur atom, and n is 2.
5. The photosensitive resin composition according to any of 1 to 4 above, further including (D) a crosslinking agent.
6. The photosensitive resin composition according to 5 above, wherein the crosslinking agent (D) is at least one compound selected from the group consisting of nitrogen-containing compounds selected from melamine compounds, guanamine compounds, glycoluril compounds and urea compounds having on average two or more methylol groups and/or alkoxymethyl groups per molecule; amino condensation products modified with formaldehyde or formaldehyde-alcohol; phenolic compounds containing on average two or more methylol groups or alkoxymethyl groups per molecule; and epoxy compounds containing on average two or more epoxy groups per molecule.
7. The photosensitive resin composition according to any of 1 to 6 above, further including (E) a solvent.
8. A photosensitive resin film obtained from the photosensitive resin composition according to any of 1 to 7 above.
9. A photosensitive dry film comprising a support film and, on the support film, the photosensitive resin film according to 8 above.
10. A patterning method comprising the steps of:
   (i) forming a photosensitive resin film on a substrate using the photosensitive resin composition according to any of 1 to 7 above,
   (ii) exposing the photosensitive resin film to light, and
   (iii) patterning the exposed photosensitive resin film by development with a developer.
11. A patterning method comprising the steps of:
   (i') forming a photosensitive resin film on a substrate using the photosensitive dry film according to 9 above,
   (ii) exposing the photosensitive resin film to light, and
   (iii) patterning the exposed photosensitive resin film by development with a developer.
12. The patterning method according to 10 or 11 above, further including the step of:
   (iv) post-curing at a temperature of between 100°C and 250°C the photosensitive resin film patterned by development.
13. The photosensitive resin composition according to any of 1 to 7 above which is a film material for protecting electrical/electronic components.
14. The photosensitive resin composition according to any of 1 to 7 above which is a substrate bonding film material for adhesively bonding two substrates.

### ADVANTAGEOUS EFFECTS OF INVENTION

The photosensitive resin composition of the invention has a good storage stability as a varnish or dry film, is capable of film formation over a broad range in film thickness, and is able as a thick film to form a fine pattern of excellent perpendicularity by the subsequently described patterning processes. The film obtained using the photosensitive resin composition and photosensitive dry film of the invention has an excellent adhesion to substrates, electronic components and semiconductor devices, especially to the base materials used in circuit boards, and also has excellent mechanical properties, electrical insulating properties, copper electromigration resistance and chemical resistance. Moreover, this film has a high reliability as a dielectric protective film, and can be advantageously used as a film-forming material for protecting various types of electrical/electronic components such as circuit boards, semiconductor devices and display devices, and also as a film-forming material for adhesively bonding substrates.

### DESCRIPTION OF EMBODIMENTS

### [Photosensitive Resin Composition]

The photosensitive resin composition of the invention includes (A) an epoxy group and/or phenolic hydroxyl group-containing silicone resin, (B) a photoacid generator having a specific structure, and (C) a benzotriazole compound.

### [(A) Silicone Resin]

The silicone resin serving as component (A) includes epoxy groups, phenolic hydroxyl groups or both on the molecule. This silicone resin is not particularly limited, although one of formula (A) below is preferred.

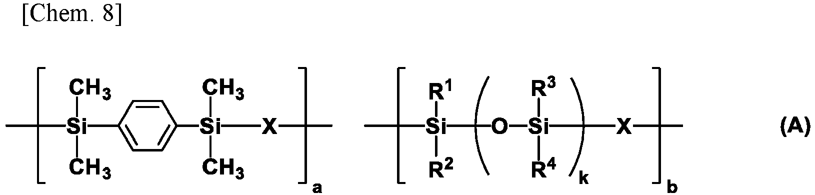

In formula (A), R¹ to R⁴ are each independently a hydrocarbyl group of 1 to 8 carbon atoms, preferably one having from 1 to 6 carbon atoms; k is an integer from 1 to 600, preferably an integer from 1 to 400, and more preferably an integer from 1 to 200; a and b are numbers which indicate the compositional ratios (molar ratios) of the respective recurring units and satisfy the conditions 0 < a < 1, 0 < b < 1 and a+b = 1; and X is an epoxy group and/or phenolic hydroxyl group-containing divalent organic group.

The hydrocarbyl group may be linear, branched or cyclic. Specific examples include alkyl groups such as methyl, ethyl, propyl and hexyl groups, as well as structural isomers of these; and cyclic saturated hydrocarbyl groups such as the cyclohexyl group; and aryl groups such as the phenyl group. Of these, methyl and phenyl groups are preferred on account of the ready availability of the starting compounds.

It is especially preferable for the silicone resin represented by formula (A) to be one that includes recurring units of formulas (a1) to (a4) and (b1) to (b4) below (also referred to below as, respectively, recurring units a1 to a4 and b1 to b4) 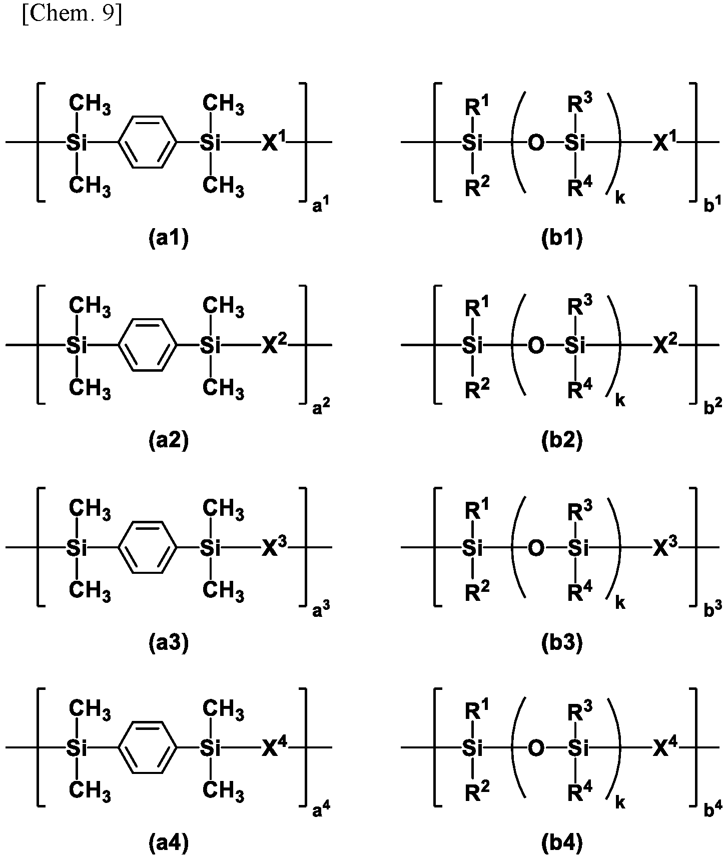 (wherein R¹ to R⁴ and k are as defined above).

In formulas (a1) and (b1), X¹ is a divalent group of formula (X1) below 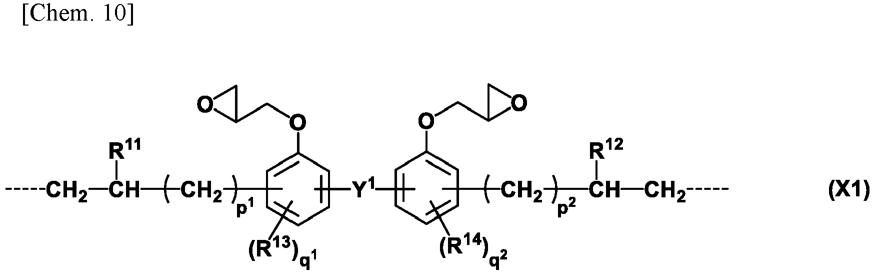 (wherein the dashed lines represent bonding sites).

In formula (X1), Y¹ is a single bond, a methylene group, a propane-2,2-diyl group, a 1,1,1,3,3,3-hexafluoropropane-2,2-diyl group or a fluorene-9,9-diyl group; R¹¹ and R¹² are each independently a hydrogen atom or a methyl group; R¹³ and R¹⁴ are each independently a saturated hydrocarbyl group of 1 to 4 carbon atoms or a saturated hydrocarbyloxy group of 1 to 4 carbon atoms; p¹ and p² are each independently an integer from 0 to 7; and q¹ and q² are each independently an integer from 0 to 2.

The saturated hydrocarbyl group may be linear, branched or cyclic. Specific examples include alkyl groups such as methyl, ethyl, propyl and butyl groups, as well as structural isomers of these; and cyclic saturated hydrocarbyl groups such as cyclopropyl and cyclobutyl groups. The saturated hydrocarbyloxy group may be linear, branched or cyclic. Specific examples include alkoxy groups such as methoxy, ethoxy, propoxy and butoxy groups, as well as structural isomers of these; and cyclic saturated hydrocarbyloxy groups such as cyclopropyloxy and cyclobutyloxy groups.

In formulas (a2) and (b2), X² is a divalent group of formula (X2) below 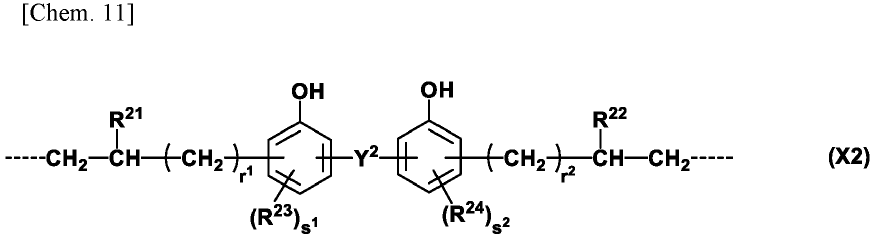 (wherein the dashed lines are bonding sites).

In formula (X2), Y² is a single bond, a methylene group, a propane-2,2-diyl group, a 1,1,1,3,3,3-hexafluoropropane-2,2-diyl group or a fluorene-9,9-diyl group; R²¹ and R²² are each independently a hydrogen atom or a methyl group; R²³ and R²⁴ are each independently a saturated hydrocarbyl group of 1 to 4 carbon atoms or a saturated hydrocarbyloxy group of 1 to 4 carbon atoms; r¹ and r² are each independently an integer from 0 to 7; and s¹ and s² are each independently an integer from 0 to 2. The saturated hydrocarbyl group and the saturated hydrocarbyloxy group are exemplified by the same groups as mentioned above in the descriptions of R¹³ and R¹⁴.

In formulas (a3) and (b3), X³ is a divalent group of formula (X3) below 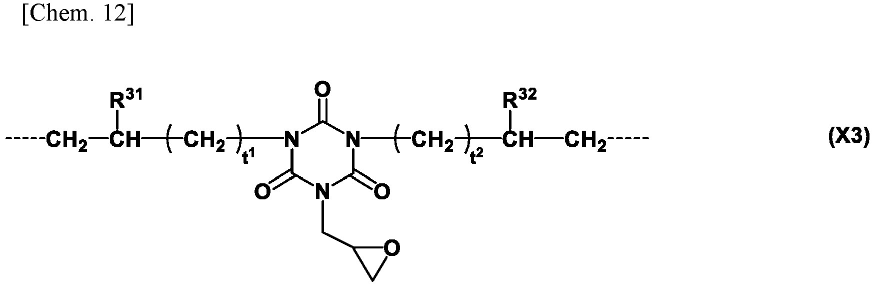 (wherein the dashed lines are bonding sites).

In formula (X3), R³¹ and R³² are each independently a hydrogen atom or a methyl group; and t¹ and t² are each independently an integer from 0 to 7.

In formulas (a4) and (b4), X⁴ is a divalent group represented by formula (X4) below 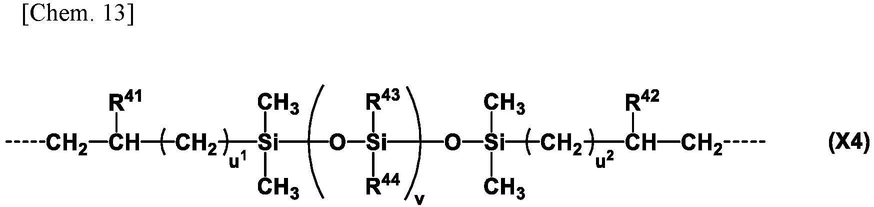 (wherein the dashed lines are bonding sites).

In formula (X4), R⁴¹ and R⁴² are each independently a hydrogen atom or a methyl group; R⁴³ and R⁴⁴ are each independently a hydrocarbyl group of 1 to 8 carbon atoms; u¹ and u² are each independently an integer from 0 to 7; and v is an integer from 0 to 600, preferably from 0 to 400, and more preferably from 0 to 200. The hydrocarbyl group is exemplified by the same groups as mentioned in the explanation of R¹ to R⁴.

The silicone resin of component (A) is one having a weight-average molecular weight (Mw) of preferably from 3,000 to 500,000, and more preferably from 5,000 to 200,000. In this invention, Mw is a polystyrene-equivalent value obtained by gel permeation chromatography using tetrahydrofuran (THF) as the eluting solvent.

In formulas (a1) to (a4) and (b1) to (b4), a¹ to a⁴ and b¹ to b⁴ are numbers which indicate the compositional ratios (molar ratios) of the respective recurring units and satisfy the conditions 0 ≤ a¹ < 1, 0 ≤ a² < 1, 0 ≤ a³ < 1, 0 ≤ a⁴ < 1, 0 ≤ b¹ < 1, 0 ≤ b² < 1, 0 ≤ b³ < 1, 0 ≤ b⁴ < 1,0 < a¹+a²+a³ < 1, 0 < b¹+b²+b³ < 1 and a¹+a²+a³+a⁴+b¹+b²+b³+b⁴ = 1; preferably satisfy the conditions 0 ≤ a¹ ≤ 0.8, 0 ≤ a² ≤ 0.8, 0 ≤ a³ ≤ 0.8, 0 ≤ a⁴ ≤ 0.8, 0 ≤ b¹ ≤ 0.95, 0 ≤ b² ≤ 0.95, 0 ≤ b³ ≤ 0.95, 0 ≤ b⁴ ≤ 0.95, 0.05 ≤ a¹+a²+a³ ≤ 0.8, 0.2 ≤ b¹+b²+b³ ≤ 0.95 and a¹+a²+a³+a⁴+b¹+b²+b³+b⁴ = 1; and more preferably satisfy the conditions 0 <_ a¹ ≤ 0.7, 0 <_ a² ≤ 0.7, 0 ≤ a³ ≤ 0.7, 0 ≤ a⁴ ≤ 0.7, 0 ≤ b¹ ≤ 0.9, 0 ≤ b² ≤ 0.9, 0 ≤ b³ ≤ 0.9, 0 ≤ b⁴ ≤ 0.9, 0.1 ≤ a¹+a²+a³ ≤ 0.7, 0.3 ≤ b¹+b²+b³ ≤ 0.9 and a¹+a²+a³+a⁴+b¹+b²+b³+b⁴ = 1.

The recurring units may be randomly bonded or may be bonded as block polymers. When there are two or more siloxane units in each recurring unit, the siloxane units in each recurring unit may all be the same or two or more differing siloxane units may be included. When two or more differing siloxane units are included, the siloxane units may be randomly bonded or a plurality of blocks of like siloxane units may be included. In the silicone resin, the silicone (siloxane unit) content is preferably from 30 to 80 wt%.

The silicone resin serving as component (A) functions as a compound that imparts film-forming ability. The resulting resin film has a good adhesion to laminates and substrates, and also has a good patternability, crack resistance and heat resistance.

The silicone resin serving as component (A) may be of one type used alone, or two or more may be used together.

### [Method of Preparing Silicone Resin (A)]

The silicone resin serving as component (A) can be prepared by addition polymerizing a compound of formula (1) below, a compound of formula (2) below, at least one compound selected from compounds of formula (3) below, compounds of formula (4) below and compounds of formula (5) below, and optionally a compound of formula (6) below in the presence of a metal catalyst. 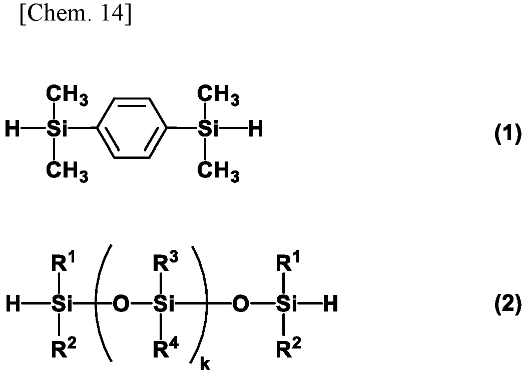 In formulas (1) and (2), R¹ to R⁴ and k are as defined above. 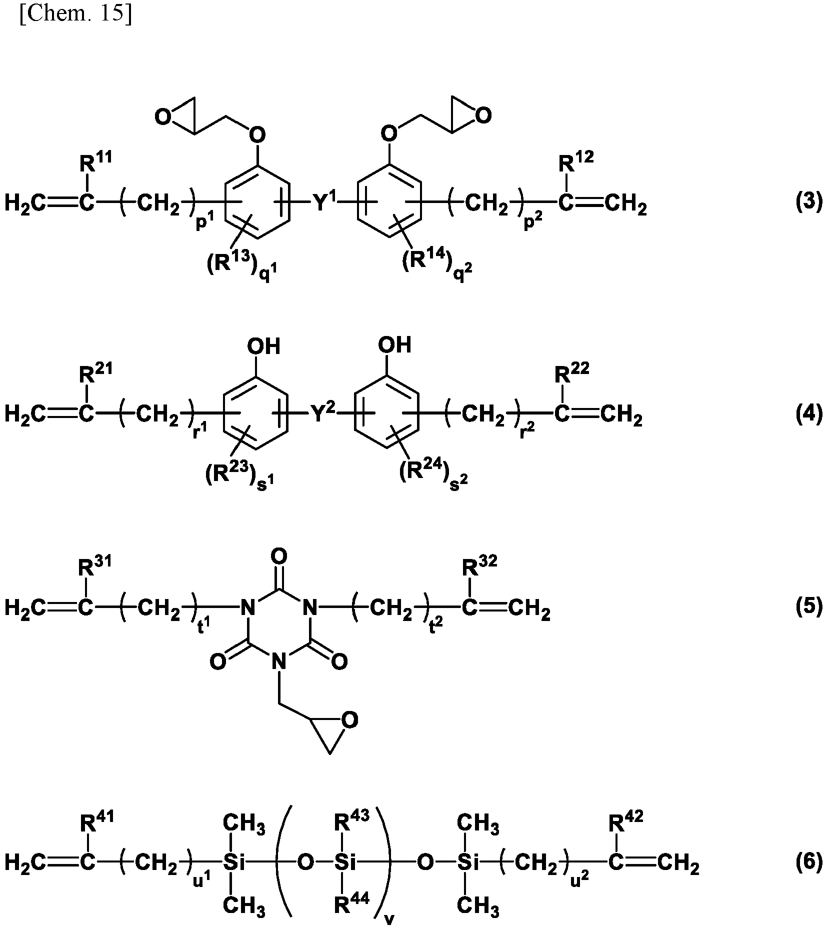 In formulas (3) to (6), R¹¹ to R¹⁴, R²¹ to R²⁴, R³¹, R³², R⁴¹ to R⁴⁴, Y¹, Y², p¹, p², q¹, q²,r¹, r², s¹, s², t¹, t², u¹, u² and v are as defined above.

The metal catalyst used is exemplified by uncombined platinum group metals such as platinum (including platinum black), rhodium and palladium; platinum chloride, chloroplatinic acid and chloroplatinic acid salts such as H₂PtCl₄·xH₂O, H₂PtCl₆·xH₂O, NaHPtCl₆·xH₂O, KHPtCl₆·xH₂O, Na₂PtCl₆·xH₂O, K₂PtCl₄·xH₂O, PtCl₄·xHzO, PtCl₂ and Na₂HPtCl₄·xHzO (wherein x is preferably an integer from 0 to 6, with 0 or 6 being especially preferred); alcohol-modified chloroplatinic acids (such as those mentioned in U.S. Pat. No. 3,220,972); complexes of chloroplatinic acid and olefins (such as those mentioned in U.S. Pat Nos. 3,159,601, 3,159,662 and 3,775,452); platinum group metals such as platinum black or palladium on a support such as alumina, silica or carbon; rhodium-olefin complexes; chlorotris(triphenylphosphine)rhodium (Wilkinson's catalyst); and complexes of platinum chloride, chloroplatinic acid or a chloroplatinic acid salt with a vinyl group-containing siloxane (especially a vinyl group-containing cyclic siloxane).

The catalyst is used in a catalytic amount that is typically from 0.001 to 0.1 part by weight, and preferably from 0.01 to 0.1 part by weight, per 100 parts by weight of the sum of the starting compounds.

A solvent may be optionally used in the addition polymerization reaction. The solvent is preferably, for example, a hydrocarbon solvent such as toluene or xylene.

From the standpoint of enabling polymerization to go to completion in a short time without a loss of catalytic activity, the polymerization temperature is preferably between 40°C and 150°C, and more preferably between 60°C and 120°C. The polymerization time varies also with the type and amount of resin to be obtained, although to keep moisture from entering the polymerization system, the polymerization time is preferably from about 0.5 to about 100 hours, and more preferably from 0.5 to 30 hours. Following reaction completion, in cases where a solvent has been used, the silicone resin serving as component (A) can be obtained by distilling off the solvent.

The reaction method is not particularly limited. For example, in cases where a compound of formula (1), a compound of formula (2), at least one compound selected from compounds of formula (3), compounds of formula (4) and compounds of formula (5), and optionally a compound of formula (6) are reacted, first the at least one compound selected from compounds of formula (3), compounds of formula (4) and compounds of formula (5) is mixed and heated together with, optionally, the compound of formula (6), the metal catalyst is then added to the mixture, following which the compound of formula (1) and the compound of formula (2) are added dropwise over a period of from 0.1 to 5 hours.

It is desirable to blend the compounds such that the sum of the hydrosilyl groups on the compound of formula (1) and the compound of formula (2) relative to the sum of the alkenyl groups on the at least one compound selected from compounds of formula (3), compounds of formula (4) and compounds of formula (5) and, optionally, the compound of formula (6), expressed as a molar ratio, is preferably from 0.67 to 1.67, and more preferably from 0.83 to 1.25.

The weight-average molecular weight of the resulting resin may be controlled by using a monoallyl compound such as o-allylphenol or a monohydrosilane or monohydrosiloxane such as triethylhydrosilane as a molecular weight regulator.

### [Photoacid Generator (B)]

The photosensitive resin composition of the invention includes a compound of formula (B) below as (B) a photoacid generator.

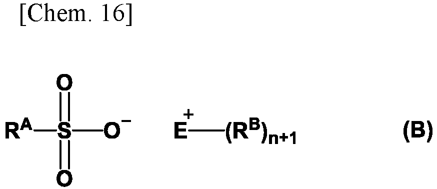

In formula (B), R^{A} is a hydrocarbyl group of 1 to 12 carbon atoms, some or all of the hydrogen atoms on which may be substituted with fluorine atoms.

In formula (B), each R^{B} is independently a monovalent organic group. R^{B} is exemplified by aromatic hydrocarbyl groups of 6 to 14 carbon atoms, saturated hydrocarbyl groups of 1 to 18 carbon atoms, and unsaturated aliphatic hydrocarbyl groups of 2 to 18 carbon atoms. The aromatic hydrocarbyl groups of 6 to 14 carbon atoms may be substituted with saturated hydrocarbyl groups of 1 to 18 carbon atoms, halogen atom-substituted saturated hydrocarbyl groups of 1 to 8 carbon atoms, unsaturated aliphatic hydrocarbyl groups of 2 to 18 carbon atoms, aromatic hydrocarbyl groups of 6 to 14 carbon atoms, nitro groups, hydroxyl groups, cyano groups, -OR^{a}, -C(=O)-R^{b}, -O-C(=O)-R^{c}, -SR^{d}, -NR^{e}R^{f} or halogen atoms. R^{a} to R^{d} are saturated hydrocarbyl groups of 1 to 8 carbon atoms or aromatic hydrocarbyl groups of 6 to 14 carbon atoms, and R^{e} and R^{f} are each independently a hydrogen atom, a saturated hydrocarbyl group of 1 to 8 carbon atoms or an aromatic hydrocarbyl group of 6 to 14 carbon atoms.

Two or more R^{B} groups may be bonded to each other either directly or through -O-, -S-, - SO-, -SO₂-, -NH-, -CO-, COO-, -CONH-, a saturated hydrocarbylene group of 1 to 20 carbon atoms or a phenylene group to form a cyclic structure that includes an element E.

In formula (B), E is a valence n element which belongs to Groups 15 to 17 of the periodical table and bonds with the organic group R^{B} to form an onium ion. Of the Group 15 to 17 elements, preferred examples include oxygen (O), nitrogen (N), phosphorus (P), sulfur (S) and iodine (I). The corresponding onium ions are oxonium ions, ammonium ions, phosphonium ions, sulfonium ions and iodonium ions. Of these, ammonium ions, phosphonium ions, sulfonium ions and iodonium ions, which are stable and easy to handle, are preferred. Sulfonium ions, which have excellent cationic polymerizability and crosslinking reactivity, are more preferred. The letter 'n' represents the valence of element E, and is an integer from 1 to 3.

Specific examples of the oxonium ions include oxonium ions such as trimethyloxonium, diethylmethyloxonium, triethyloxonium and tetramethylenemethyloxonium ions; pyrylium such as 4-methylpyrylium, 2,4,6-trimethylpyrylium, 2,6-di-tert-butylpyrylium and 2,6-diphenylpyrylium; chromenium such as 2,4-dimethylchromenium; and isochromenium such as 1,3 -dimethylisochromenium.

Specific examples of the ammonium ions include tetraalkylammonium ions such as the tetramethylammonium ion, ethyltrimethylammonium ion, diethyldimethylammonium ion, triethylmethylammonium ion and tetraethylammonium ion; pyrrolidinium ions such as the N,N-dimethylpyrrolidinium ion, N-ethyl-N-methylpyrrolidinium ion and N,N-diethylpyrrolidinium ion; imidazolinium ions such as the N,N'-dimethylimidazolinium ion, N,N'-diethylimidazolinium ion, N-ethyl-N'-methylimidazolinium ion, 1,3,4-trimethylimidazolinium ion and 1,2,3,4-tetramethylimidazolinium ion; tetrahydropyrimidinium ions such as the N,N'-dimethyltetrahydropyrimidinium ion; morpholinium ions such as the N,N'-dimethylmorpholinium ion; piperidinium ions such as the N,N'-diethylpiperidinium ion; pyridinium ions such as the N-methylpyridinium ion, N-benzylpyridinium ion and N-phenacylpyridinium ion; imidazolinium ions such as the N,N'-dimethylimidazolinium ion; quinolinium ions such as the N-methylquinolinium ion, N-benzylquinolinium ion and N-phenacylquinolinium ion; isoquinolinium ions such as the N-methylisoquinolinium ion; thiazonium ions such as the benzylbenzothiazonium ion and phenacylbenzothiazonium ion; and acridinium ions such as the benzylacryidinium ion and phenacylacridinium ion.

Specific examples of the phosphonium ions include tetraarylphosphonium ions such as the tetraphenylphosphonium ion, tetra-p-tolylphosphonium ion, tetrakis(2-methoxyphenyl)phosphonium ion, tetrakis(3-methoxyphenyl)phosphonium ion and tetrakis(4-methoxyphenyl)phosphonium ion; triarylphosphonium ions such as the triphenylbenzylphosphonium ion, triphenylphenacylphosphonium ion, triphenylmethylphosphonium ion and triphenylbutylphosphonium ion; and tetraalkylphosphonium ions such as the triethylbenzylphosphonium ion, tributylbenzylphosphonium ion, tetraethylphosphonium ion, tetrabutylphosphonium ion, tetrahexylphosphonium ion, triethylphenacylphosphonium ion and tributylphenacylphosphonium ion.

Specific examples of the sulfonium ions include triarylsulfonium ions such as the triphenylsulfonium ion, tri-p-tolylsulfonium ion, tri-o-tolylsulfonium ion, tris(4-methoxyphenyl)sulfonium ion, 1-naphthyldiphenylsulfonium ion, 2-naphthyldiphenylsulfonium ion, tris(4-fluorophenyl)sulfonium ion, tri-1-naphthylsulfonium ion, tri-2-naphthylsulfonium ion, tris(4-hydroxyphenyl)sulfonium ion, 4-(phenylthio)phenyldiphenylsulfonium ion, 4-(p-tolylthio)phenyldi-p-tolylsulfonium ion, 4-(4-methoxyphenylthio)phenylbis(4-methoxyphenyl)sulfonium ion, 4-(phenylthio)phenylbis(4-fluorophenyl)sulfonium ion, 4-(phenylthio)phenylbis(4-methoxyphenyl)sulfonium ion, 4-(phenylthio)phenyldi-p-tolylsulfonium ion, [4-(4-biphenylylthio)phenyl]-4-biphenylylphenylsulfonium ion, [4-(2-thioxanthonylthio)phenyl]diphenylsulfonium ion, bis[4-(diphenylsulfonio)phenyl] sulfide ion, bis[4-{bis[4-(2-hydroxyethoxy)phenyl]sulfonio}phenyl]sulfide ion, bis{4-[bis(4-fluorophenyl)sulfonio]phenyl}sulfide ion, bis{4-[bis(4-methylphenyl)sulfonio]phenyl}sulfide ion, bis{4-[bis(4-methoxyphenyl)sulfonio]phenyl}sulfide ion, 4-(4-benzoyl-2-chlorophenylthio)phenylbis(4-fluorophenyl)sulfonium ion, 4-(4-benzoyl-2-chlorophenylthio)phenyldiphenylsulfonium ion, 4-(4-benzoylphenylthio)phenylbis(4-fluorophenyl)sulfonium ion, 4-(4-benzoylphenylthio)phenyldiphenylsulfonium ion, 7-isopropyl-9-oxo- 10-thia-9,10-dihydroanthracen-2-yldi-p-tolylsulfonium ion, 7-isopropyl-9-oxo-10-thia-9, 10-dihydroanthracen-2-yldiphenylsulfonium ion, 2-[(di-p-tolyl)sulfonio]thioxanthone ion, 2-[(diphenyl)sulfonio]thioxanthone ion, 4-(9-oxo-9H-thioxanthen-2-yl)thiophenyl-9-oxo-9H-thioxanthen-2-ylphenylsulfonium ion, 4-[4-(4-tert-butylbenzoyl)phenylthio]phenyldi-p-tolylsulfonium ion, 4-[4-(4-tert-butylbenzoyl)phenylthio]phenyldiphenylsulfonium ion, 4-[4-(benzoylphenylthio)]phenyldi-p-tolylsulfonium ion, 4-[4-(benzoylphenylthio)]phenyldiphenylsulfonium ion, 5-(4-methoxyphenyl)thianthrenium ion, 5-phenylthianthrenium ion, 5-tolylthianthrenium ion, 5-(4-ethoxyphenyl)thianthrenium ion and 5-(2,4,6-trimethylphenyl)thianthrenium ion; diarylsulfonium ions such as the diphenylphenacylsulfonium ion, diphenyl-4-nitrophenacylsulfonium ion, diphenylbenzylsulfonium ion and diphenylmethylsulfonium ion; monoarylsulfonium ions such as the phenylmethylbenzylsulfonium ion, 4-hydroxyphenylmethylbenzylsulfonium ion, 4-methoxyphenylmethylbenzylsulfonium ion, 4-acetocarbonyloxyphenylmethylbenzylsulfonium ion, 4-hydroxyphenyl(2-naphthylmethyl)methylsulfonium ion, 2-naphthylmethylbenzylsulfonium ion, 2-naphthylmethyl(1-ethoxycarbonyl)ethylsulfonium ion, phenylmethylphenacylsulfonium ion, 4-hydroxyphenylmethylphenacylsulfonium ion, 4-methoxyphenylmethylphenacylsulfonium ion, 4-acetocarbonyloxyphenylmethylphenacylsulfonium ion, 2-naphthylmethylphenacylsulfonium ion, 2-naphthyloctadecylphenacylsulfonium ion and 9-anthracenylmethylphenacylsulfonium ion; and trialkylsulfonium ions such as the dimethylphenacylsulfonium ion, phenacyltetrahydrothiophenium ion, dimethylbenzylsulfonium ion, benzyltetrahydrothiophenium ion and octadecylmethylphenacylsulfonium ion.

Specific examples of the iodonium ions include the diphenyliodonium ion, di-p-tolyliodonium ion, bis(4-dodecylphenyl)iodonium ion, bis(4-methoxyphenyl)iodonium ion, (4-octyloxyphenyl)phenyliodonium ion, bis(4-decyloxy)phenyliodonium ion, 4-(2-hydroxytetradecyloxy)phenylphenyliodonium ion, 4-isopropylphenyl(p-tolyl)iodonium ion and 4-isobutylphenyl(p-tolyl)iodonium ion.

From the standpoint of the photocurability, the content of component (B) per 100 parts by weight of component (A) is preferably from 0.05 to 20 parts by weight, and more preferably from 0.1 to 10 parts by weight. At a component (B) content of 0.05 part by weight or more, sufficient acid is generated and the crosslinking reaction fully proceeds. A content of 20 parts by weight or less is preferable because light absorbance by the photoacid generator itself can be kept from increasing and there is no risk that the problem of a decrease in transparency will arise. Component (B) may be of one type used alone, or two or more may be used in combination.

### [(C) Benzotriazole Compound]

The photosensitive resin composition of the invention includes a benzotriazole compound as component (C). Adding a benzotriazole compound contributes to a number of advantageous effects when used with the photoacid generator of component (B). One such advantage is the emergence of a good quencher effect. Because it is able to hold down the rate of diffusion when the acid generated by the photoacid generator diffuses within a photocurable resin layer, including a benzotriazole compound improves the resolution, suppresses changes in sensitivity following exposure, lowers substrate and environmental dependence, and can improve the exposure latitude and pattern profile. Another advantage is that a good catalytic effect is achieved during the post-cure, enabling a cured film of excellent reliability and electromigration resistance to be obtained. Moreover, because there is no increase in the viscosity of the varnish on account of reactions between functional groups proceeding at room temperature and no decrease in the viscosity of the varnish on account of siloxane cleavage, the composition also has an excellent storage stability. In addition, the reactions do not proceed at room temperature even in the dry film, and so the patternability also has an excellent storage stability.

The benzotriazole compound is preferably one of formula (C1) or (C2) below.

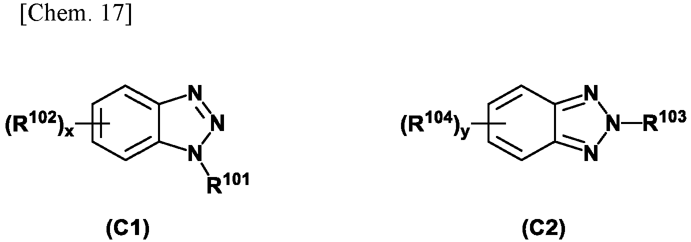

In formulas (C1) and (C2), R¹⁰¹ and R¹⁰³ are each independently a hydrogen atom, a hydroxyl group, an aliphatic hydrocarbyl group of 1 to 8 carbon atoms, a saturated hydrocarbyloxy group of 1 to 8 carbon atoms or an aryl group of 6 to 24 carbon atoms.

The aliphatic hydrocarbyl groups of 1 to 8 carbon atoms represented by R¹⁰¹ and R¹⁰³ may be saturated or unsaturated, and may be linear, branched or cyclic. Specific examples include alkyl groups such as methyl, ethyl, propyl, butyl, pentyl, hexyl, heptyl and octyl groups, as well as structural isomers thereof; cyclic saturated hydrocarbyl groups such as cyclopropyl and cyclobutyl groups; and alkenyl groups such as vinyl, propenyl, butenyl, pentenyl, hexenyl, heptenyl and octenyl groups, as well as structural isomers thereof.

The saturated hydrocarbyloxy groups of 1 to 8 carbon atoms represented by R¹⁰¹ and R¹⁰³ may be linear, branched or cyclic. Specific examples include methoxy, ethoxy and propoxy groups.

Examples of the aryl groups of 6 to 24 carbon atoms represented by R¹⁰¹ and R¹⁰³ include phenyl and naphthyl groups, as well as these groups in which some or all hydrogen atoms are substituted with aliphatic hydrocarbyl groups of 1 to 8 carbon atoms or aralkyl groups of 7 to 10 carbon atoms. These aliphatic hydrocarbyl groups of 1 to 8 carbon atoms are exemplified by the same groups as those mentioned as examples of the aliphatic hydrocarbyl group of 1 to 8 carbon atoms represented by R¹⁰¹ and R¹⁰³. The aralkyl groups of 7 to 15 carbon atoms are exemplified by benzyl, 1-phenylethyl, 2-phenylethyl, 3-phenyl-1-propyl and 2-phenyl-2-propyl groups.

Some or all of the hydrogen atoms on the above aliphatic hydrocarbyl groups and aryl groups may be substituted with hydroxyl groups, and some of the -CH₂- moieties on the aliphatic hydrocarbyl groups may be substituted with ether bonds or ester bonds. Examples of groups in which some or all of the hydrogen atoms on the aliphatic hydrocarbyl groups and aryl groups are substituted with hydroxyl groups include hydroxymethyl, 2-hydroxyethyl and hydroxyphenyl groups. Examples of groups in which some of the -CH₂- moieties on the aliphatic hydrocarbyl groups are substituted with ether bonds or ester bonds include methoxymethyl, methoxyethyl, ethoxymethyl, ethoxyethyl, (meth)acryloylethyl and (meth)acryloylpropyl groups.

In formulas (C1) and (C2), R¹⁰² and R¹⁰⁴ are each independently a halogen atom or a hydrocarbyl group of 1 to 6 carbon atoms; some or all of the hydrogen atoms on these hydrocarbyl group may be substituted with fluorine atoms. Examples of the halogen atoms include fluorine, chlorine, bromine and iodine atoms. Examples of the hydrocarbyl group of 1 to 6 carbon atoms include alkyl groups such as methyl, ethyl, propyl, butyl, pentyl and hexyl groups, as well as structural isomers of these; cyclic aromatic hydrocarbyl groups such as cyclopropyl and cyclobutyl groups; alkenyl groups such as vinyl, propenyl, butenyl, pentenyl and hexenyl groups, as well as structural isomers of these; and the phenyl group. Examples of the fluorine atom-substituted hydrocarbyl groups include fluoromethyl, difluoromethyl, trifluoromethyl, 2,2,2-trifluoroethyl, pentafluoroethyl and 1,1,1,3,3,3-hexafluoro-2-propyl groups.

In formulas (C1) and (C2), x and y are each independently an integer from 0 to 4.

Examples of the benzotriazole compound include benzotriazole, 1-(methoxymethyl)-1H-benzotriazole, 2-n-octylbenzotriazole, methyl-1H-benzotriazole, 1-methyl-1H-benzotriazole, 1H-benzotriazole-1-methanol, 1-hydroxy-6-(trifluoromethyl)benzotriazole, 2-[2-hydroxy-5-[2-(methacryloyloxy)ethyl]phenyl]-2H-benzotriazole, 5,6-dimethyl-1,2,3-benzotriazole, 5-chlorobenzotriazole, 4,5,6,7-tetrabromobenzotriazole, 2-(2-hydroxy-5-methylphenyl)benzotriazole, 2-(2H-benzotriazol-2-yl)-4,6-bis(1-methyl-1-phenylethyl)phenol and 2-(2H-benzotriazol-2-yl)-4-methyl-6-(2-propenyl)phenol.

From the standpoint of compatibility, the quencher effect and promotion of the cure during post-curing, the content of component (C) per 100 parts by weight of component (A) is preferably from 0.01 to 10 parts by weight, and more preferably form 0.01 to 3 parts by weight. At a component (C) content of 0.01 part by weight or more, a sufficient quencher effect and curability are obtained; a content of 10 parts by weight or less is desirable because the compatibility with component (A) is good and there is no risk that the problem of a decrease in transparency will arise. Component (C) may be of one type used alone or two or more may be used in combination.

### [Component (D)]

The photosensitive resin composition of the invention preferably further includes, as component (D), a crosslinking agent. This crosslinking agent gives rise to condensation reactions with phenolic hydroxyl groups on component (A) or with saturated hydrocarbyloxy groups represented by R¹³, R¹⁴, R²³ or R²⁴. It is an ingredient for facilitating pattern formation and also further increases the strength of the cured product.

Examples of the crosslinking agent include melamine compounds, guanamine compounds, glycoluril compounds and urea compounds having on average two or more methylol and/or alkoxymethyl groups per molecule; amino condensation products modified with formaldehyde or formaldehyde-alcohol; phenolic compounds having on average two or more methylol or alkoxymethyl groups per molecule; and epoxy compounds having on average two or more epoxy groups per molecule.

Examples of the melamine compounds include those of formula (D1) below.

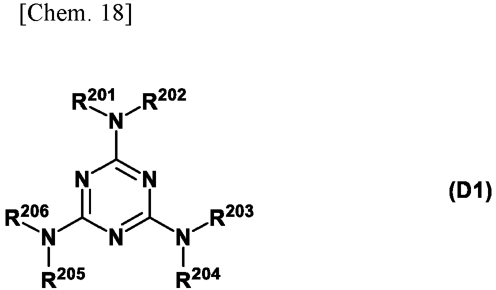

In formula (D1), R²⁰¹ to R²⁰⁶ are each independently a methylol group, a saturated hydrocarbyloxymethyl group of 2 to 5 carbon atoms or a hydrogen atom, with at least one being a methylol group or a saturated hydrocarbyloxymethyl group. Examples of the saturated hydrocarbyloxymethyl group include alkoxymethyl groups such as methoxymethyl and ethoxymethyl groups.

Specific examples of melamine compounds of formula (D1) include trimethoxymethylmonomethylolmelamine, dimethoxymethylmonomethylolmelamine, trimethylolmelamine, hexamethylolmelamine, hexamethoxymethylmelamine and hexaethoxymethylmelamine.

The melamine compound of formula (D1) can be obtained by, for example, first modifying melamine monomer by methylolation with formaldehyde according to a known method, or by further modifying this by alkoxylation with an alcohol. This alcohol is preferably a lower alcohol such as an alcohol having 1 to 4 carbon atoms.

Examples of the guanamine compound include tetramethylolguanamine, tetramethoxymethylguanamine and tetramethoxyethylguanamine.

Examples of the glycoluril compound include tetramethylolglycoluril and tetrakis(methoxymethyl)glycoluril.

Examples of the urea compound include tetramethylolurea, tetramethoxymethylurea, tetramethoxyethylurea, tetraethoxymethylurea and tetrapropoxymethylurea.

Examples of the amino condensation products modified with formaldehyde or formaldehyde-alcohol include melamine condensation products obtained by modification with formaldehyde or formaldehyde-alcohol and urea condensation products obtained by modification with formaldehyde or formaldehyde-alcohol.

Examples of the modified melamine condensation products include ones obtained by the addition condensation polymerization of a compound of formula (D1) or a multimer thereof (e.g., an oligomer such as a dimer or trimer) with formaldehyde up to the desired molecular weight. A known method may be used as the addition condensation polymerization method. Modified melamines of formula (D1) may be used singly or two or more may be used in combination.

Examples of urea condensation products modified with formaldehyde or formaldehyde-alcohol include methoxymethylated urea condensation products, ethoxymethylated urea condensation products and propoxymethylated urea condensation products.

The modified urea condensation product can be obtained by, for example, modifying a urea condensation product of the desired molecular weight by methylolation with formaldehyde in accordance with a known method, or by further modifying this by alkoxylation with an alcohol.

Examples of phenolic compounds having on average two or more methylol or alkoxymethyl groups per molecule include (2-hydroxy-5-methyl)-1,3-benzenedimethanol and 2,2',6,6'-tetramethoxymethylbisphenol A.

Examples of epoxy compounds having on average two or more epoxy groups per molecule include bisphenol-type epoxy resins such as bisphenol A-type epoxy resins and bisphenol F-type epoxy resins, novolac-type epoxy resins such as phenolic novolac-type epoxy resins and cresol novolac-type epoxy resins, triphenolalkane-type epoxy resins, biphenyl-type epoxy resins, dicyclopentadiene-modified phenolic novolac-type epoxy resins, phenolic aralkyl-type epoxy resins, biphenylaralkyl-type epoxy resins, naphthalene ring-containing epoxy resins, glycidyl ester-type epoxy resins, alicyclic epoxy resins and heterocyclic epoxy resins.

When component (D) is included, the content thereof per 100 parts by weight of component (A) is preferably from 0.5 to 50 parts by weight, and more preferably from 1 to 30 parts by weight. At 0.5 part by weight or more, sufficient curability can be obtained when irradiated with light; at 50 parts by weight or less, the proportion of component (A) within the photosensitive resin composition does not decrease, enabling satisfactory effects to be achieved in the cured product. Component (D) may be of one type used alone or two or more may be used in combination.

### [(E) Solvent]

The photosensitive resin composition of the invention may further include, as component (E), a solvent. The solvent is not particularly limited, so long as it is a solvent capable of dissolving components (A) to (D) and the various subsequently described additives. However, organic solvents are preferred because of their excellent ability to dissolve these ingredients.

Examples of the organic solvent include ketones such as cyclohexanone, cyclopentanone and methyl-2-n-pentyl ketone; alcohols such as 3-methoxybutanol, 3-methyl-3-methoxybutanol, 1-methoxy-2-propanol and 1-ethoxy-2-propanol; ethers such as propylene glycol monomethyl ether (PGME), ethylene glycol monomethyl ether, propylene glycol monoethyl ether, ethylene glycol monoethyl ether, propylene glycol dimethyl ether and diethylene glycol dimethyl ether; and esters such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate and γ-butyrolactone. Ethyl lactate, cyclohexanone, cyclopentanone, PGMEA, γ-butyrolactone and mixed solvents thereof, which are best able to dissolve the photoacid generator, are especially preferred. These organic solvents may be of one type used singly or two or more may be used in admixture.

From the standpoint of the compatibility and viscosity of the photosensitive resin composition, the content of component (E) per 100 parts by weight of component (A) is preferably from 50 to 2,000 parts by weight, more preferably from 50 to 1,000 parts by weight, and even more preferably from 50 to 100 parts by weight. Component (E) may be of one type used alone, or two or more may be used in combination.

### [Other Additives]

In addition to the above ingredients, the photosensitive resin composition of the invention may include also other additives. Examples of such other additives include surfactants that are commonly used, for example, to increase the coatability of photosensitive resin compositions.

The surfactant is preferably one that is nonionic, such as a fluorosurfactant, examples of which include perfluoroalkyl polyoxyethylene ethanols, fluorinated alkyl esters, perfluoroalkylamine oxides and fluorine-containing organosiloxane compounds. Commercially available products may be used as these. Specific examples include Fluorad^{®} FC-430 (from 3M Company), Surfion^{®} S-141 and S-145 (from AGC Seimi Chemical Co., Ltd.), Unidyne^{®} DS-401, DS-4031 and DS-451 (from Daikin Industries, Ltd.), Megaface^{®} F-8151 (from DIC Corporation) and X-70-093 (Shin-Etsu Chemical Co., Ltd.). Of these, Fluorad FC-430 and X-70-093 are preferred. The content of this surfactant is preferably from 0.05 to 1 part by weight per 100 parts by weight of component (A).

Another additive that may be included in the photosensitive resin composition of the invention is a silane coupling agent. By including a silane coupling agent, adhesion of the film obtained from this composition to the adherend can be further increased. The silane coupling agent is exemplified by epoxy group-containing silane coupling agents and aromatic group-containing aminosilane coupling agents. These may be of one type used alone or two or more may be used in combination. The content of the silane coupling agent is not particularly limited. However, when such a silane coupling agent is included, the content is preferably from 0.01 to 5 wt% of the photosensitive resin composition of the invention.

Preparation of the inventive photosensitive resin composition is carried out by a conventional method. For example, the photosensitive resin composition of the invention can be prepared by stirring and mixing together the above ingredients and, if necessary, subsequently filtering off the solids with a filter or the like.

The inventive photosensitive resin composition that has been thus prepared can be suitably used as, for example, a protective film for semiconductor devices, a protective film for wiring, a coverlay film, a solder mask, a dielectric film material for through-silicon vias (TSVs), and also as an adhesive between laminated substrates in three-dimensional lamination.

### [Patterning Process Using Photosensitive Resin Composition]

A patterning process that uses the photosensitive resin composition of the invention includes the steps of:
(i) forming a photosensitive resin film on a substrate using the photosensitive resin composition of the invention,
(ii) exposing the photosensitive resin film to light, and
(iii) patterning the exposed photosensitive resin film by development with a developer.

Step (i) forms a photosensitive resin film on a substrate using the above photosensitive resin composition. Exemplary substrates include silicon wafers, TSV wafers, silicon wafers worked to a thin film by backside polishing, plastic or ceramic substrates, and substrates on some or all of the surface of which a metal such as nickel or gold has been deposited by ion sputtering, plating or the like. Substrates with an uneven surface are also sometimes used.

The method of forming a photosensitive resin film may involve, for example, applying the photosensitive resin composition onto a substrate and, if necessary, prebaking the applied composition. Application may be carried out by a known method, such as dipping, spin coating or roll coating. The photosensitive resin composition is applied in an amount which may be suitably selected according to the intended purpose, although it is desirable to apply the composition in such a way that the thickness of the resulting photosensitive resin film becomes preferably from 0.1 to 200 µm, and more preferably from 1 to 150 µm.

Before applying the photosensitive resin composition, a solvent may be added dropwise to the substrate (prewetting method) in order to improve the film thickness uniformity on the substrate surface. The solvent and amount thereof that is added dropwise can be suitably selected according to the intended purpose. Preferred examples of this solvent include alcohols such as isopropyl alcohol (IPA), ketones such as cyclohexanone, and glycols such as PGME, although the solvent employed in the photosensitive resin composition may also be used for this purpose.

To carry out the photocuring reaction efficiently, if necessary, the solvent, etc. may be evaporated by carrying out a pre-bake, typically at between 40°C and 140°C for a period of from about 1 minute to about 1 hour.

Next, step (ii) exposes the photosensitive resin film to light. Exposure at this time is preferably carried out with light having a wavelength of from 10 to 600 nm, and is more preferably carried out with light having a wavelength of from 190 to 500 nm. Examples of light having such a wavelength include light of various wavelengths generated by, for example, a radiation generator, such as g-line, h-line and i-line ultraviolet light and far-infrared light (248 nm, 193 nm). Of these, light having a wavelength of between 248 and 436 nm is especially preferred. The exposure dose is preferably from 10 to 10,000 mJ/cm².

Exposure may be carried out through a photomask. The photomask may be one in which a desired pattern has been cut out. The photomask material is not particularly limited, although a material which screens out light of the above wavelength is preferred. For example, a photomask having a light-shielding film of chromium or the like can be suitably used.

In addition, a post-exposure bake (PEB) may be carried out to increase the sensitivity of development. This PEB is preferably carried out at between 40°C and 150°C for 0.5 to 10 minutes. The PEB causes the exposed areas to crosslink, forming a pattern which is insoluble to the organic solvent serving as the developer.

Following exposure or PEB, step (iii) patterns the exposed photosensitive resin film by development with a developer. Preferred examples of the developer include organic solvents such as alcohols (e.g., IPA), ketones (e.g., cyclohexanone) and glycols (e.g., PGME), although the solvent used in the photosensitive resin composition may also be employed for this purpose. The method of development may be a conventional method, such as that of immersing the pattern-bearing substrate in the developer. Development with an organic solvent dissolves and removes unexposed areas, forming a pattern. Washing, rinsing and drying are subsequently carried out as needed, giving a resin film having the desired pattern.

In step (iv), the patterned film may be post-cured in an oven or on a hot plate at preferably between 100°C and 250°C, and more preferably between 150°C and 220°C. At a post-cure temperature between 100°C and 250°C, the crosslink density of the photosensitive resin composition can be increased and remaining volatile ingredients can be removed, which is desirable from the standpoint of adhesion to the substrate, heat resistance, strength, electrical characteristics and bonding strength. The post-cure time is preferably from 10 minutes to 10 hours, and more preferably from 10 minutes to 3 hours. Using the photosensitive resin composition of the invention, a film of various excellent film properties can be obtained even with a relatively low temperature post-cure at about 200°C. The thickness of the film after the post-cure (cured film) is generally from 1 to 200 µm, and preferably from 5 to 50 µm.

When there is no need to form a pattern, such as in cases where one wishes to form simply a uniform film, film formation may be carried out by, in step (ii) of the above patterning method, exposure to light of a suitable wavelength without an intervening photomask.

### [Method for Adhesively Bonding Substrates]

The photosensitive resin composition of the invention can also be used as an adhesive for bonding two substrates. The substrate bonding method is exemplified by a method which adhesively bonds, under suitable heat and pressure conditions, a substrate on which has been formed a film of the inventive photosensitive resin composition with a second substrate in such a way as to create an adhesive bond between the two substrates. The substrate on which the film has been formed and the second substrate are either or both sometimes diced or otherwise separated into chips. The bonding conditions are preferably set to a heating temperature of between 50°C and 200°C and a bonding time of from 1 to 60 minutes. Using a wafer bonder as the bonding device, wafers may be attached to each other under a vacuum while applying a load, or chip-wafer or chip-chip bonding may be carried out using a flip chip bonder. The bonding strength of the adhesive layer formed between the substrates increases with the subsequently described post-cure, forming a permanent bond.

By carrying out, under the same conditions as in above Step (iv), a post-cure on the attached (adhesively bonded) substrate, the crosslink density of the film rises, enabling the substrate bonding strength to be increased. Crosslinking reactions arise due to heating at the time of bonding, but side-reactions with outgassing do not arise in these crosslinking reactions and so, particularly in cases where the inventive photosensitive resin composition is used as a substrate adhesive, such use does not give rise to lamination defects (voids).

### [Photosensitive Dry Film]

The photosensitive dry film of the invention has a support film and, on the support film, a photosensitive resin film obtained from the above-described photosensitive resin composition.

The photosensitive dry film (support film and photosensitive resin film) is a solid. The photosensitive resin film does not include a solvent, eliminating the risk of bubbles resulting from solvent vaporization being left at the interior of the photosensitive resin film and between the photosensitive resin film and a substrate having an uneven surface.

The photosensitive resin film has a thickness which, from the standpoint of the film planarity on a substrate having an uneven surface, step coverage and substrate lamination spacing, is preferably from 5 to 200 µm, and more preferably from 10 to 100 µm.

A close association exists between the viscosity and flowability of the photosensitive resin film. Within an appropriate viscosity range, the photosensitive resin film can exhibit suitable flowability and penetrate deep into narrow gaps, or the resin softens and thereby enhances adhesion with the substrate. Accordingly, from the standpoint of flowability, the photosensitive resin film has a viscosity at 80 to 120°C which is preferably from 10 to 5,000 Pa·s, more preferably from 30 to 2,000 Pa.s, and even more preferably from 50 to 300 Pa.s. In this invention, the viscosity is a value measured with a rotational viscometer.

When the photosensitive dry film of the invention is closely bonded to a substrate having asperities on the surface, the photosensitive resin film covers the substrate while conforming to the asperities, enabling a high planarity to be achieved. Because this photosensitive resin film is characterized by having a low viscoelasticity, a higher planarity can be achieved. In addition, when this photosensitive resin film is bonded to the substrate in a vacuum environment, the generation of gaps therebetween can be more effectively prevented.

The photosensitive dry film of the invention can be produced by applying the photosensitive resin composition onto a support film and drying the composition to form a photosensitive resin film. Film coaters commonly used to produce pressure-sensitive adhesive products can be employed as the apparatus for producing the photosensitive dry film. Examples of such film coaters include comma coaters, comma reverse coaters, multicoaters, die coaters, lip coaters, lip reverse coaters, direct gravure coaters, offset gravure coaters, three-roll bottom reverse coaters and four-roll bottom reverse coaters.

Production of a photosensitive dry film can be carried out as follows. The support film is unwound from a supply shaft and passed across the head of the film coater, at which time the photosensitive resin composition is applied onto the support film to a predetermined thickness. The coated support film is then passed through a circulating hot-air oven at a predetermined temperature for a predetermined length of time, drying the photosensitive resin composition on the support film to form a photosensitive resin film. Alternatively, where necessary, a photosensitive dry film with a protective film thereon can be produced by passing the photosensitive dry film, together with a protective film that has been unwound from another supply shaft in the film coater, across a laminating roll under a predetermined pressure to laminate the photosensitive resin film and the protective film onto the support film, and then taking up the laminate on a take-up shaft in the film coater. The temperature in this case is preferably between 25°C and 150°C, the time is preferably from 1 to 100 minutes, and the pressure is preferably from 0.01 to 5 MPa.

The support film may be a one-layer film or may a multilayer film obtained by laminating a plurality of films. Examples of the film material include synthetic resin films made of polyethylene, polypropylene, polycarbonate and polyethylene terephthalate. Of these, polyethylene terephthalate is preferred from the standpoint of a suitable flexibility, mechanical strength and heat resistance. These films may ones that have been subjected to various treatments such as corona treatment or release agent application. Such films are commercially available as, for example, Cerapeel WZ(RX) and Cerapeel BX8(R) from Toray Advanced Film Co., Ltd., E7302 and E7304 from Toyobo Co., Ltd., Purex G31 and Purex G71T1 from Teijin DuPont Film Co., Ltd., and PET38×1-A3, PET38×1-V8 and PET38×1-X08 from Nippa Corporation.

The protective film used on the photosensitive dry film may be similar to the support film described above. Polyethylene terephthalate and polyethylene films are preferred on account of their suitable flexibility. Such films are also commercially available. In addition to the polyethylene terephthalate films mentioned above, examples of commercially available polyethylene films include GF-8 from Tamapoly Co., Ltd. and PE film O type from Nippa Corporation.

To ensure the stability of the photosensitive dry film product and prevent curling with respect to the winding core, the thicknesses of the support film and the protective film are preferably each from 10 to 100 µm, and more preferably from 25 to 50 µm.

### [Patterning Process Using Photosensitive Dry Film]

A patterning process that uses the photosensitive dry film of the invention includes the steps of:
(i') forming a photosensitive resin film on a substrate using the photosensitive dry film of the invention,
(ii) exposing the photosensitive resin film to light, and
(iii) patterning the exposed photosensitive resin film by development with a developer.

Step (i') uses a photosensitive dry film to form a photosensitive resin film on a substrate. Specifically, the photosensitive resin film side of a photosensitive dry film is attached to a substrate, thereby forming a photosensitive film on the substrate. Alternatively, in cases where the photosensitive dry film has a protective film, the photosensitive resin film side of the photosensitive dry film is attached to the substrate after peeling the protective film from the photosensitive dry film. Attachment may be carried out using, for example, a film applicator.

The substrate is exemplified by the same substrates as those described above in connection with the patterning process using a photosensitive resin composition. The film applicator is preferably a vacuum laminator. For example, the protective film on the photosensitive dry film is peeled off and, within a vacuum chamber set to a predetermined degree of vacuum, the uncovered photosensitive resin film is adhesively bonded to the substrate on a table at a predetermined temperature using an applicator roll under a predetermined pressure. The temperature is preferably between 60°C and 120°C, the pressure is preferably from 0 to 5.0 MPa, and the degree of vacuum is preferably from 50 to 500 Pa.

If necessary, film attachment may be carried out a plurality of times to obtain a photosensitive resin film of the required thickness. For example, photosensitive resin film having a thickness of about 10 to 1,000 µm, preferably about 100 to 500 µm, can be obtained by carrying out such film attachment from 1 to 10 times.

If necessary, a pre-bake may be carried to efficiently carry out the photocuring reactions on the photosensitive resin film and also enhance adhesion between the photosensitive resin film and the substrate. The pre-bake may be carried out at, for example, between 40°C and 140°C for a period of from about 1 minute to about 1 hour.

The photosensitive resin film that has been attached to a substrate can be patterned by, as in the case of the above-described patterning process using a photosensitive resin composition, the steps of (ii) exposing the photosensitive resin film to light, (iii) patterning the exposed photosensitive resin film by development with a developer and, optionally, (iv) post-curing. Depending on the patterning process used, the support film of the photosensitive dry film is peeled off before the pre-bake or before the post-exposure bake, or is removed by another method.

The films obtained from the above-described photosensitive resin composition and photosensitive dry film have excellent heat resistance, flexibility, electrical insulating properties, mechanical properties and adhesion to the substrate, enabling them to be advantageously used as protective films for electrical/electronic components such as semiconductor devices and as substrate bonding films.

### EXAMPLES

Synthesis Examples, Examples according to the invention and Comparative Examples are given below to more concretely illustrate the invention, although the invention is not limited by these Examples. The weight-average molecular weight (Mw) was measured by gel permeation chromatography against monodispersed polystyrene as the standard using a TSKgeL Super HZM-H column (Tosoh Corporation) and under the following conditions: a flow rate of 0.6 mL/min, using tetrahydrofuran (THF) as the eluting solvent, and a column temperature of 40°C.

Compounds (S-1) to (S-6) used in the Synthesis Examples are shown below.

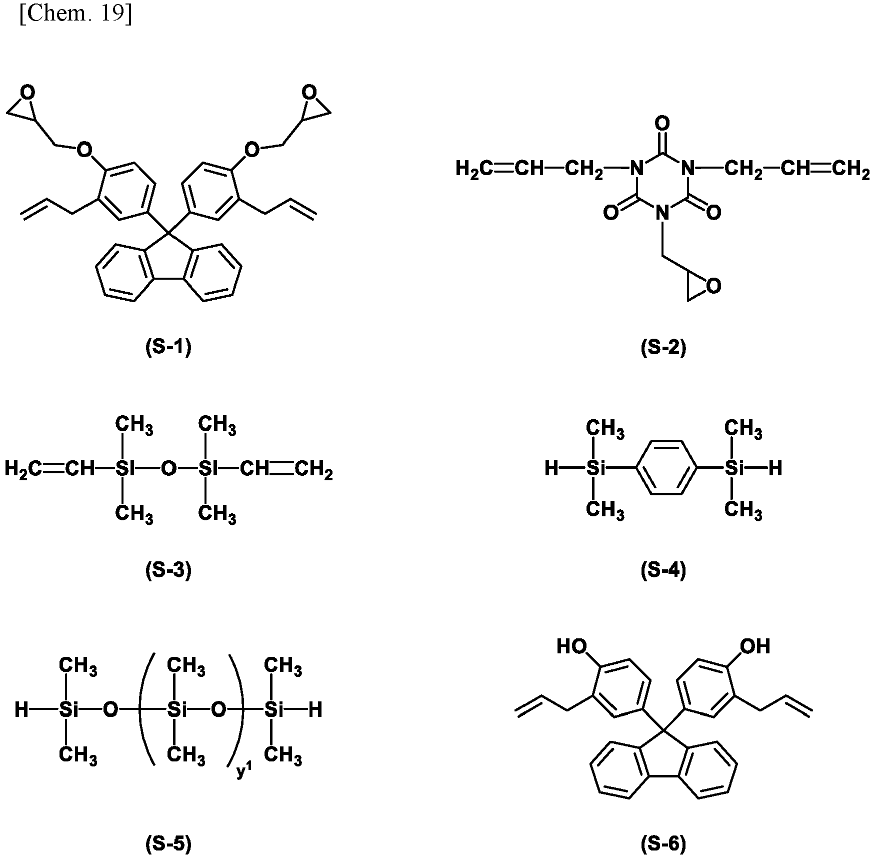

### [1] Silicone Resin Synthesis

### [Synthesis Example 1]

A three-liter flask equipped with a stirrer, thermometer, nitrogen purging system and reflux condenser was charged with 215.0 g (0.5 mol) of Compound (S-6), following which 2,000 g of toluene was added and the flask contents were heated to 70°C. Next, 1.0 g of a toluene solution of chloroplatinic acid (platinum concentration, 0.5 wt%) was added and 67.9 g (0.35 mol) of compound (S-4) and 453.0 g (0.15 mol) of compound (S-5) (y¹ = 40; from Shin-Etsu Chemical Co., Ltd.) were added dropwise over one hour (total hydrosilyl groups/total alkenyl groups = 1/1 (molar ratio)). Following the completion of dropwise addition, the flask contents were heated to 100°C and aged for 6 hours, after which the toluene was driven off under reduced pressure from the reaction solution, giving Silicone Resin A-1. Silicone Resin A-1 was confirmed by analysis with a ¹H-NMR spectrometer (Bruker) to include recurring units a1, a2, b1 and b2. Silicone Resin A-1 had a Mw of 62,000 and a silicone content of 61.6 wt%.

### [Synthesis Example 2]

A three-liter flask equipped with a stirrer, thermometer, nitrogen purging system and reflux condenser was charged with 53.00 g (0.20 mol) of Compound (S-2) and 117.6 g (0.30 mol of Compound (S-1), following which 2,000 g of toluene was added and the flask contents were heated to 70°C. Next, 1.0 g of a toluene solution of chloroplatinic acid (platinum concentration, 0.5 wt%) was added and 48.5 g (0.25 mol) of compound (S-4) and 755.0 g (0.25 mol) of compound (S-5) (y¹ = 40; from Shin-Etsu Chemical Co., Ltd.) were added dropwise over one hour (total hydrosilyl groups/total alkenyl groups = 1/1 (molar ratio)). Following the completion of dropwise addition, the flask contents were heated to 100°C and aged for 6 hours, after which the toluene was driven off under reduced pressure from the reaction solution, giving Silicone Resin A-2. Silicone Resin A-2 was confirmed by analysis with a ¹H-NMR spectrometer (Bruker) to include recurring units a1, a3, a4, b1, b3 and b4. Silicone Resin A-2 had a Mw of 83,000 and a silicone content of 77.5 wt%.

### [Synthesis Example 3]

A three-liter flask equipped with a stirrer, thermometer, nitrogen purging system and reflux condenser was charged with 27.9 g (0.15 mol) of Compound (S-3), 19.6 g (0.05 mol of Compound (S-1) and 129.0 g (0.30 mol) of Compound (S-6), following which 2,000 g of toluene was added and the flask contents were heated to 70°C. Next, 1.0 g of a toluene solution of chloroplatinic acid (platinum concentration, 0.5 wt%) was added and 87.3 g (0.45 mol) of compound (S-4) and 79.3 g (0.05 mol) of compound (S-5) (y¹ = 20; from Shin-Etsu Chemical Co., Ltd.) were added dropwise over one hour (total hydrosilyl groups/total alkenyl groups = 1/1 (molar ratio)). Following the completion of dropwise addition, the flask contents were heated to 100°C and aged for 6 hours, after which the toluene was driven off under reduced pressure from the reaction solution, giving Silicone Resin A-3. Silicone Resin A-3 was confirmed by analysis with a ¹H-NMR spectrometer (Bruker) to include recurring units a1, a2, a4, b1, b2 and b4. Silicone Resin A-3 had a Mw of 24,000 and a silicone content of 31.2 wt%.

### [2] Preparation of Photosensitive Resin Compositions

### [Examples 1 to 12 and Comparative Examples 1 to 19]

The ingredients were compounded in the amounts shown in Tables 1 to 3 and then stirred at normal room temperature and dissolved, following which microfiltration was carried out with a Teflon^{®} 1.0 µm filter, thereby preparing the photosensitive resin compositions in Examples 1 to 12 and Comparative Examples 1 to 19.

**[Table 1]**

| Ingredients (pbw) | | | Example | | | | | | | | | | | |
|---|---|---|---|---|---|---|---|---|---|---|---|---|---|---|
| | | | 1 | 2 | 3 | 4 | 5 | 6 | 7 | 8 | 9 | 10 | 11 | 12 |
| (A) | Silicone resin | A-1 | 100 | 100 | 100 | 100 | - | - | - | - | - | - | - | - |
| | | A-2 | - | - | - | - | 100 | 100 | 100 | 100 | - | - | - | - |
| | | A-3 | - | - | - | - | - | - | - | - | 100 | 100 | 100 | 100 |
| (B) | Photoacid generator | B-1 | 3 | - | - | - | 10 | - | - | - | 0.1 | - | - | - |
| | | B-2 | - | 3 | - | - | - | 10 | - | - | - | 0.1 | - | - |
| | | B-3 | - | - | 3 | - | - | - | 10 | - | - | - | 0.1 | - |
| | | B-4 | - | - | - | 3 | - | - | - | 10 | - | - | - | 0.1 |
| (C) | Benzotriazole compound | C-1 | 0.4 | - | 0.2 | - | 2 | - | 1 | - | 0.02 | - | 0.01 | - |
| | | C-2 | - | 0.4 | - | 0.2 | - | 2 | - | 1 | - | 0.02 | - | 0.01 |
| (D) | Crosslinking agent | CL-1 | 3 | 10 | 30 | 15 | - | - | - | - | 5 | 15 | - | - |
| | | CL-2 | - | - | - | 15 | 1 | 20 | - | - | 5 | - | 30 | - |
| (E) | Solvent | cyclopentanone | 55 | 55 | 55 | 55 | 55 | 55 | 55 | 55 | 55 | 55 | 55 | 55 |

**[Table 2]**

| Ingredients (pbw) | | | Comparative Example | | | | | | | | | | |
|---|---|---|---|---|---|---|---|---|---|---|---|---|---|
| | | | 1 | 2 | 3 | 4 | 5 | 6 | 7 | 8 | 9 | 10 | 11 |
| (A) | Resin | A-1 | 100 | 100 | 100 | - | - | - | - | - | - | - | - |
| | | A-2 | - | - | - | 100 | 100 | 100 | 100 | - | - | - | - |
| | | A-3 | - | - | - | - | - | - | - | 100 | 100 | 100 | 100 |
| | | A'-1 | - | - | - | - | - | - | - | - | - | - | - |
| (B) | Photoacid generator | B-1 | 3 | 3 | 3 | - | - | - | - | - | - | - | - |
| | | B-3 | - | - | - | 3 | 3 | 3 | - | - | - | - | - |
| | | B'-1 | - | - | - | - | - | - | 3 | - | - | - | - |
| | | B'-2 | - | - | - | - | - | - | - | 3 | - | - | - |
| | | B'-3 | - | - | - | - | - | - | - | - | 3 | - | - |
| | | B'-4 | - | - | - | - | - | - | - | - | - | 3 | - |
| | | B'-5 | - | - | - | - | - | - | - | - | - | - | 3 |
| (C) | Additive | C-1 | - | - | - | - | - | - | 0.4 | 0.4 | 0.4 | - | - |
| | | C-2 | - | - | - | - | - | - | - | - | - | 0.4 | 0.4 |
| | | C'-1 | 0.4 | - | - | - | - | - | - | - | - | - | - |
| | | C'-2 | - | 0.4 | - | - | - | - | - | - | - | - | - |
| | | C'-3 | - | | 0.4 | - | - | - | - | - | - | - | - |
| | | C'-4 | - | - | - | 0.4 | - | - | - | - | - | - | - |
| | | C'-5 | - | - | - | - | 0.4 | - | - | - | - | - | - |
| | | C'-6 | - | - | - | - | - | 0.4 | - | - | - | - | - |
| (D) | Crosslinking agent | CL-1 | 3 | 10 | 30 | - | - | - | - | 5 | 15 | - | - |
| | | CL-2 | - | - | - | 1 | 20 | - | - | 5 | - | 30 | - |
| (E) | Solvent | cyclopentanone | 55 | 55 | 55 | 55 | 55 | 55 | 55 | 55 | 55 | 55 | 55 |

**[Table 3]**

| Ingredients (pbw) | | | Comparative Example | | | | | | | |
|---|---|---|---|---|---|---|---|---|---|---|
| | | | 12 | 13 | 14 | 15 | 16 | 17 | 18 | 19 |
| (A) | Resin | A-1 | 100 | 100 | - | - | - | - | - | - |
| | | A-2 | - | - | 100 | 100 | - | - | - | - |
| | | A-3 | - | - | - | - | 100 | 100 | - | - |
| | | A'-1 | - | - | - | - | - | - | 100 | 100 |
| (B) | Photoacid generator | B-1 | - | - | - | - | - | - | 3 | - |
| | | B-3 | - | - | - | - | - | - | - | 3 |
| | | B'-1 | 10 | - | - | - | - | 0.1 | - | - |
| | | B'-2 | - | 10 | - | - | - | - | - | - |
| | | B'-3 | - | - | 10 | - | - | - | - | - |
| | | B'-4 | - | - | - | 0.1 | - | - | - | - |
| | | B'-5 | - | - | - | - | 0.1 | - | - | - |
| (C) | Additive | C-1 | - | - | - | - | - | - | 0.4 | - |
| | | C-2 | - | - | - | - | - | - | - | 0.4 |
| | | C'-1 | 2 | - | - | - | - | - | - | - |
| | | C'-2 | - | 2 | - | - | - | - | - | - |
| | | C'-3 | - | - | 2 | - | - | - | - | - |
| | | C'-4 | - | - | - | 0.02 | - | - | - | - |
| | | C'-5 | - | - | - | - | 0.02 | - | - | - |
| | | C'-6 | - | - | - | - | - | 0.02 | - | - |
| (D) | Crosslinking agent | CL-1 | 3 | 10 | - | - | 5 | - | 5 | 10 |
| | | CL-2 | - | - | 1 | 20 | 5 | - | 25 | - |
| (E) | Solvent | cyclopentanone | 55 | 55 | 55 | 55 | 55 | 55 | 55 | 55 |

In Tables 1 to 3, B-1 to B-4 and B'-1 to B'-5 are as follows.

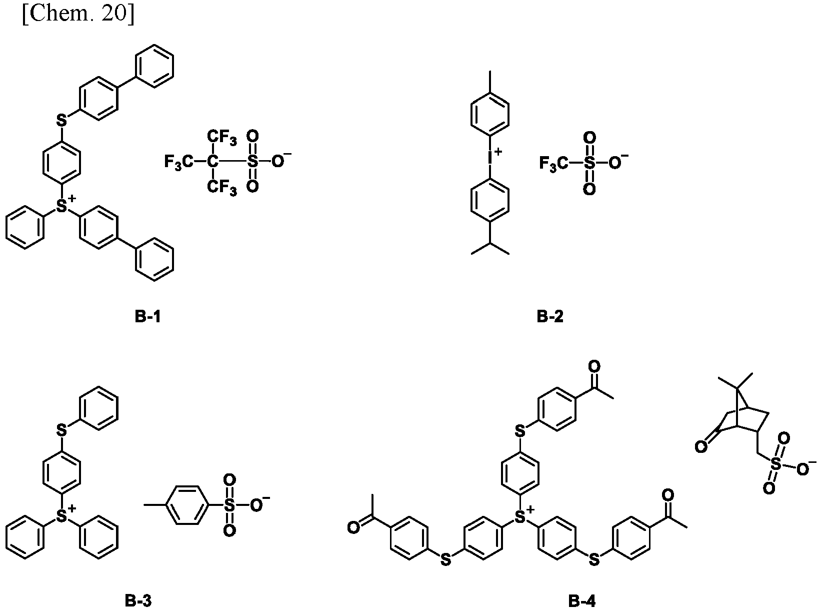

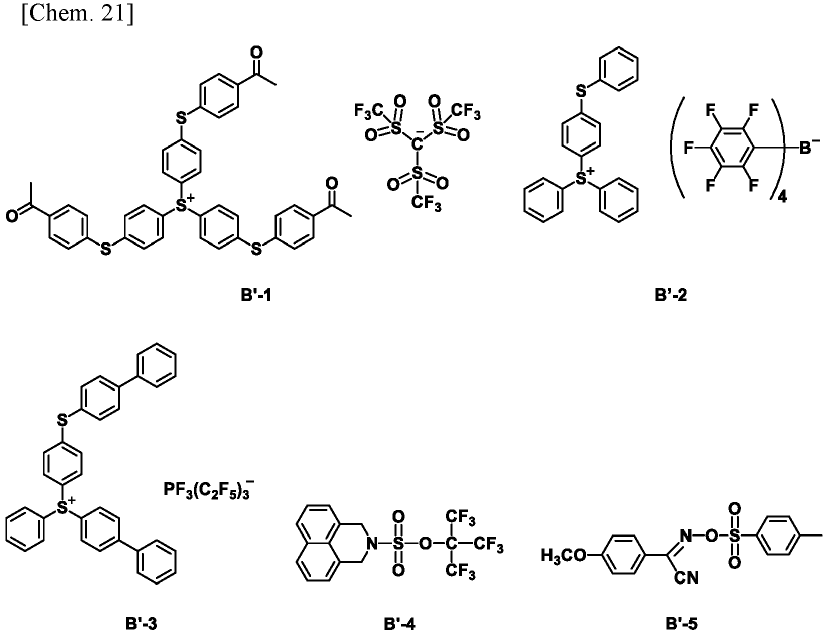

In Tables 1 to 3, C-1, C-2 and C'-1 to C'-6 are as follows.

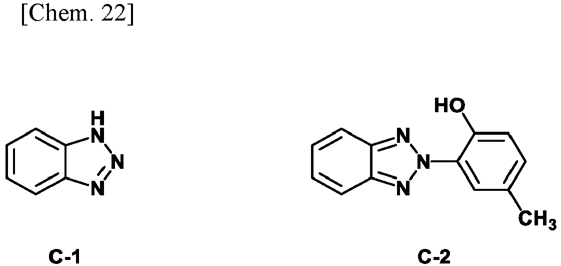

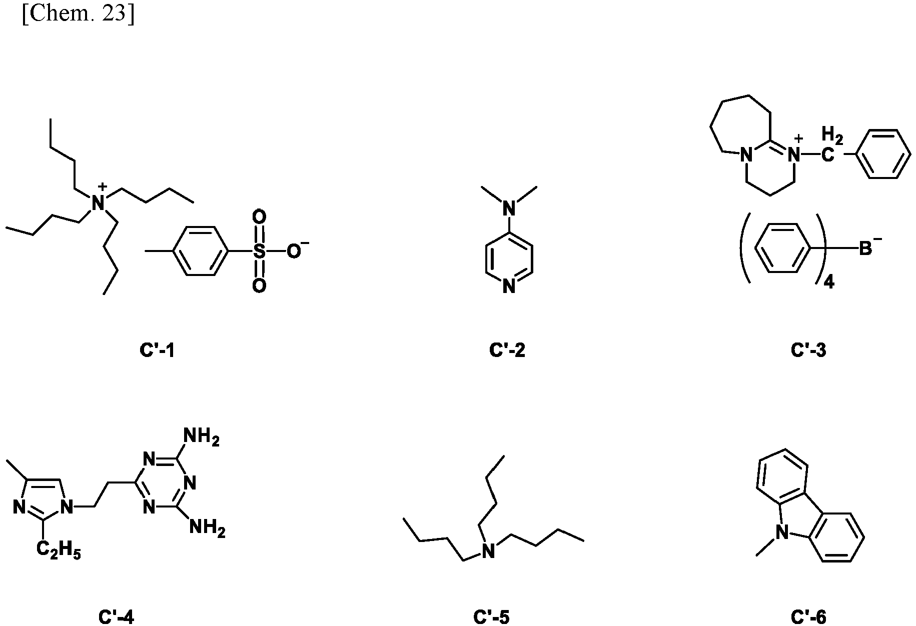

In Tables 1 to 3, CL-1 and CL-2 are as follows.

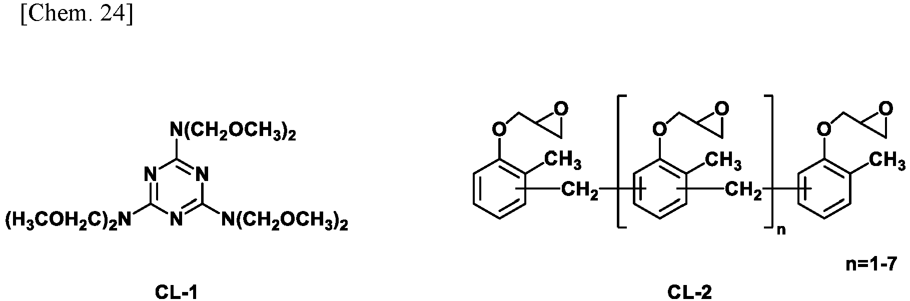

In Tables 2 and 3, A'-1 is as follows.

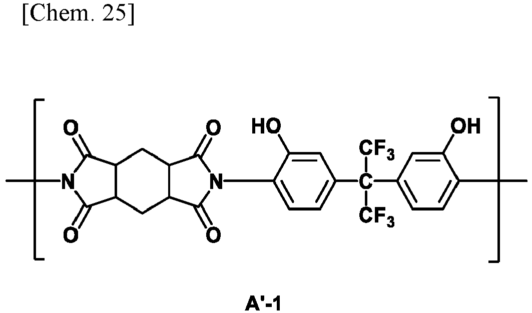

### [3] Storage Stability of Varnish

The viscosities of the photosensitive resin composition varnishes in Tables 1 to 3 were measured using the RB-85R viscometer from Tokisangyo. These varnishes were then stored 360 days at room temperature (25°C) and under light-shielded conditions, following which the viscosities were measured again. The storage stability was rated as "○" when the percent change in viscosity after 360 days relative to the first day was less than ±10%, and was rated as "×" when it was ±10% or more. The results are shown in Tables 4 to 6.

### [4] Production of Photosensitive Dry Film

Using a die coater as the film coater and a polyethylene terephthalate film (thickness, 75 µm) as the support film, the photosensitive resin composition varnishes in Tables 1 to 3 were each coated onto a support film. The applied varnish was then dried by passing the coated film for 5 minutes through a circulating hot-air oven (length 4 m) set to 100°C, thereby forming a photosensitive resin film on the support film to give a photosensitive dry film. A polyethylene film (thickness, 50 µm) was laminated as a protective film to the photosensitive resin film from above with a laminating roll under a pressure of 1 MPa, thereby producing a photosensitive dry film with attached protective film. The thickness of each photosensitive resin film was set to 150 µm. The thicknesses of the photosensitive resin films were measured with a light interference-type film thickness gauge (F50-EXR, from Filmetrics Japan, Inc.).

### [5] Resin Film Evaluation

### (1) Patterning, Patterning Evaluation, and Evaluation of Storage Stability

Patterning was carried out one day after production of the photosensitive dry film with attached protective film. The protective film was stripped from the photosensitive dry film and, using the TEAM-100RF vacuum laminator (Takatori Corporation), the degree of vacuum within the vacuum chamber was set to 80 Pa and the photosensitive resin film on the support film was closely bonded to an electromigration test substrate (a comb-shaped electrode substrate in which the conductive material is copper, the conductor spacing and width are both 20 µm, and the conductor thickness is 4 µm). The temperature was set to 100°C. After restoring the pressure to atmospheric pressure, the substrate was taken out of the laminator and the support film was stripped off. Next, to increase adhesion to the substrate, a 5-minute pre-bake at 120°C was carried out on a hot plate. Using a contact aligner, the resulting photocurable resin film was exposed to 405 nm wavelength light through a mask so as to form a line-and-space pattern and a contact hole pattern. Following exposure, a 5-minute post-exposure bake (PEB) at 140°C was carried out on a hot plate, after which the photocurable resin film was cooled and subjected to 300 seconds of spray development with PGMEA to effect pattern formation.

The patterned photosensitive resin film on the substrate was post-cured in an oven at 150°C for 4 hours under nitrogen purging. Cross-sectional profiles of 300 µm, 150 µm, 100 µm, 70 µm and 50 µm contact hole patterns were examined with a scanning electron microscope (SEM) and the smallest hole pattern in which the holes reached the bottom of the film was treated as the limiting resolution. In addition, the perpendicularity of the 300 µm contact hole pattern was evaluated from the resulting cross-sectional image. A perpendicular pattern was rated as "⊚"; a profile in which a reverse tapered shape or footing is somewhat visible was rated as "○"; a profile in which a reverse tapered shape or footing is clearly apparent was rated as "△"; and a hole opening failure was rated as "×". The results are presented in Tables 4 to 6.

Also, the photosensitive dry film was stored for 360 days at room temperature (25°C) under light-shielded conditions, following which a similar pattern was formed by the above-described method. The patterned photosensitive resin film on a substrate was post-cured in an oven at 170°C for 2 hours under nitrogen purging. Cross-sectional profiles of the resulting 300 µm, 150 µm, 100 µm, 70 µm and 50 µm contact hole patterns were examined with a SEM, and the smallest hole pattern in which the holes reach the bottom of the film was treated as the limiting resolution. In addition, the perpendicularity of the 300 µm contact hole pattern was evaluated from the resulting cross-sectional image. A perpendicular pattern was rated as "⊚"; a profile in which a reverse tapered shape or footing is somewhat visible was rated as "○"; a profile in which a reverse tapered shape or footing is clearly apparent was rated as "△"; and a hole opening failure was rated as "×". The results are presented in Tables 4 to 6.

### (2) Evaluation of Electrical Property (Copper Electromigration)

A test was carried out using a substrate that was patterned by the method in Evaluation (1) above as the substrate for evaluating copper electromigration. The copper electromigration test was carried out at a temperature of 130°C, 85% humidity and under an applied voltage of 10 V, and the time when shorting arose, with 1,000 hours as the upper limit, was determined. The results are presented in Tables 4 to 6.

### (3) Evaluation of Electrical Property (Dielectric Breakdown Strength)

To evaluate the dielectric breakdown strength of a photosensitive resin film obtained from a photosensitive resin composition, the photosensitive resin compositions in Tables 1 to 3 were applied with a bar coater onto 13 cm by 15 cm iron plates having a thickness of 0.7 mm, exposed using a contact aligner to 405 nm wavelength light without an intervening mask, and subsequently heated in an oven for 2 hours at 170°C, thereby obtaining in each case a photosensitive resin film. The photosensitive resin composition was applied in such a way as to give the resulting film a thickness of 0.2 µm. Using this photosensitive resin film, voltage was applied at a voltage rise rate of 5 volts per second with the TM-5031AM dielectric breakdown tester (Tamadensoku Co., Ltd.), the voltage when the test specimen failed was measured and this value was treated as the dielectric breakdown strength of the film. The results are presented in Tables 4 to 6.

### (4) Evaluation of Reliability (Adhesion, Crack Resistance)

The protective film was stripped from the above-described photosensitive dry film with attached protective film and, using the TEAM-100RF vacuum laminator (Takatori Corporation), the degree of vacuum within the vacuum chamber was set to 80 Pa, and the photosensitive resin film on a support film was closely bonded to a CCL substrate having 10 mm × 10 mm square silicon chips mounted thereon. The temperature was set to 100°C. After restoring the pressure to atmospheric pressure, the substrate was taken out of the laminator and the support film was stripped off. Next, a 5-minute pre-bake at 120°C was carried out on a hot plate so as to increase adhesion to the substrate. Using a contact aligner, the resulting photocurable resin film was exposed to 405 nm wavelength light without an intervening mask. Exposure was followed by a 5-minute post-exposure bake at 140°C on a hot plate, then cooling, and the photocurable resin film was post-cured in an oven at 170°C for 2 hours under nitrogen purging. Using a dicing saw equipped with a dicing blade (DAD685, from DISCO; spindle speed, 40,000 rpm; cutting speed, 20 mm/sec), 20 mm × 20 mm square test pieces were obtained in such a way that the silicon chip on each test piece had a surrounding border of 5 mm. The resulting test pieces (ten in each Example) were furnished to a heat cycling test (in which 1,000 cycles were repeated, each cycle consisting of holding the test pieces at -30°C for 10 minutes and then holding them at 130°C for 10 minutes), and then checked for resin film peeling from the wafer and for the presence or absence of cracks following the heat cycling test. When no peeling or cracks whatsoever occurred, the reliability was rated as "○"; when peeling occurred in even one test piece, the reliability was rated as "×"; when cracks arose in even one test piece, the reliability was rated as "×." Peeling and the presence or absence of cracks were checked by top-down observation under an optical microscope and by cross-sectional SEM microscopy. The results are presented in Tables 4 to 6.

### (5) Evaluation of Bonding Performance between Substrates

To evaluate the bonding performance between substrates, the protective film was stripped from the photosensitive dry film with attached protective film described above and, using the TEAM-100RF vacuum laminator (Takatori Corporation), the degree of vacuum within the vacuum chamber was set to 80 Pa and the photosensitive resin film on a support film was closely bonded to an 8-inch silicon wafer. The temperature was set to 100°C. After restoring the pressure to atmospheric pressure, the substrate was taken out of the laminator and the support film was stripped off. Next, a 5-minute pre-bake at 120°C was carried out on a hot plate so as to increase adhesion to the substrate. Using a contact aligner, the resulting photocurable resin film was exposed to 405 nm wavelength light through a mask so as to form a 300 µm line-and-space pattern. Exposure was followed by a 5-minute post-exposure bake (PEB) at 140°C on a hot plate, then cooling, and 300 seconds of spray development with PGMEA was carried out, forming a pattern. The substrate was then laminated with an untreated 8-inch quartz glass or Tempax glass wafer, and 5 minutes of temporary bonding and heating at 150°C was carried out on a hot plate. This was followed by a 2-hour post-cure at 170°C in an oven, thereby forming a substrate-to-substrate bonding layer. The wafer after bonding was exposed for 1,000 hours to a temperature of 130°C and 85% humidity, and checked for the presence or absence of induced lamination defects. The results are presented in Tables 4 to 6.

### (6) Evaluation of Solvent Resistance

To evaluate the solvent resistance to N-methyl-2-pyrrolidone (NMP), which is commonly used when forming semiconductor devices and the like, 15 mm × 15 mm patterns of the photosensitive resin compositions in Examples 1 to 12 and Comparative Examples 1 to 19 were formed on silicon wafers in the same way as in the production of wafers for the copper electromigration test in Evaluation (1) above. In each case, the wafer was immersed for one hour in NMP at 40°C, following which the change in film thickness and the appearance were investigated, and the solvent resistance was evaluated. When there was no change in appearance or film thickness, the solvent resistance was rated as "○"; when swelling or the like was confirmed, the solvent resistance was rated as "×." The results are presented in Tables 4 to 6.

### (7) Evaluation of Relative Permittivity and Dielectric Loss Tangent

The protective film was stripped from the above-described photosensitive dry film with attached protective film and, using a contact aligner, was exposed to 405 nm wavelength light without an intervening mask. The exposed photosensitive resin film was then post-cured in an oven at 170°C for 2 hours under nitrogen purging. The photosensitive resin film was taken out of the oven and the support film was stripped off, following which the relative permittivity (10 GHz, 25°C) and dielectric loss tangent (10 GHz, 25°C) were measured. The relative permittivity and the dielectric loss tangent were measured by the cavity resonator method using an apparatus from AET, Inc. The results are presented in Tables 4 to 6.

**[Table 4]**

| | | Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Storage stability of varnish | | ○ | ○ | ○ | ○ | ○ | ○ | ○ | ○ | ○ | ○ | ○ | ○ |
| After 1 day | Limiting resolution (µm) | 70 | 70 | 70 | 70 | 70 | 70 | 70 | 70 | 70 | 70 | 70 | 70 |
| | Pattern profile | ⊚ | ⊚ | ⊚ | ⊚ | ⊚ | ⊚ | ⊚ | ⊚ | ⊚ | ⊚ | ⊚ | ⊚ |
| After 360 days | Limiting resolution (µm) | 70 | 70 | 70 | 70 | 70 | 70 | 70 | 70 | 70 | 70 | 70 | 70 |
| | Pattern profile | ⊚ | ⊚ | ⊚ | ⊚ | ⊚ | ⊚ | ⊚ | ⊚ | ⊚ | ⊚ | ⊚ | ⊚ |
| Copper electromigration test (shorting time, hr) | | no shorting | no shorting | no shorting | no shorting | no shorting | no shorting | no shorting | no shorting | no shorting | no shorting | no shorting | no shorting |
| Dielectric breakdown strength (V/µm) | | 540 | 520 | 520 | 500 | 520 | 530 | 520 | 530 | 510 | 510 | 500 | 520 |
| Reliability | Adhesion | ○ | ○ | ○ | ○ | ○ | ○ | ○ | ○ | ○ | ○ | ○ | ○ |
| | Crack resistance | ○ | ○ | ○ | ○ | ○ | ○ | ○ | ○ | ○ | ○ | ○ | ○ |
| Presence/Absence of bonding defect induction | | no | no | no | no | no | no | no | no | no | no | no | no |
| Solvent resistance | | ○ | ○ | ○ | ○ | ○ | ○ | ○ | ○ | ○ | ○ | ○ | ○ |
| Relative permittivity | | 2.6 | 2.6 | 2.6 | 2.6 | 2.6 | 2.6 | 2.7 | 2.7 | 2.6 | 2.6 | 2.7 | 2.7 |
| Dielectric loss tangent (×10⁻²) | | 1.2 | 1.3 | 1.4 | 1.2 | 1.3 | 1.4 | 1.5 | 1.5 | 1.4 | 1.3 | 1.5 | 1.4 |

**[Table 5]**

| | | Comparative Example | | | | | | | | | | |
|---|---|---|---|---|---|---|---|---|---|---|---|---|
| | | 1 | 2 | 3 | 4 | 5 | 6 | 7 | 8 | 9 | 10 | 11 |
| Storage stability of varnish | | × | × | × | × | × | × | × | × | × | × | × |
| After 1 day | Limiting resolution (µm) | 100 | 100 | 100 | 100 | 100 | 100 | 300 | 300 | 300 | 300 | 300 |
| | Pattern profile | Δ | Δ | Δ | Δ | Δ | Δ | ○ | ○ | ○ | ○ | ○ |
| After 360 days | Limiting resolution (µm) | 300 | 300 | 300 | 300 | 300 | 300 | × | 300 | 300 | × | × |
| | Pattern profile | Δ | Δ | Δ | Δ | Δ | Δ | × | Δ | Δ | × | × |
| Copper electromigration test (shorting time, hr) | | 300 | 300 | 300 | 300 | 300 | 300 | 100 | 500 | 500 | 100 | 100 |
| Dielectric breakdown strength (V/µm) | | 380 | 360 | 370 | 370 | 360 | 390 | 380 | 390 | 360 | 350 | 360 |
| Reliability | Adhesion | × | × | × | × | × | × | × | × | × | × | × |
| | Crack resistance | × | × | × | × | × | × | × | × | × | × | × |
| Presence/Absence of bonding defect induction | | yes | yes | yes | yes | yes | yes | yes | yes | yes | yes | yes |
| Solvent resistance | | × | × | × | × | × | × | × | × | × | × | × |
| Relative permittivity | | 3.3 | 3.3 | 3.3 | 3.3 | 3.2 | 3.2 | 3.3 | 3.3 | 3.3 | 3.4 | 3.4 |
| Dielectric loss tangent (×10⁻²) | | 2.9 | 2.8 | 2.8 | 2.9 | 2.8 | 2.8 | 3.1 | 3.0 | 3.0 | 2.8 | 2.7 |

**[Table 6]**

| | | Comparative Example | | | | | | | |
|---|---|---|---|---|---|---|---|---|---|
| | | 12 | 13 | 14 | 15 | 16 | 17 | 18 | 19 |
| Storage stability of varnish | | × | × | × | × | × | × | × | × |
| After 1 day | Limiting resolution (µm) | 300 | 300 | 150 | 300 | 300 | 300 | 300 | 300 |
| | Pattern profile | Δ | Δ | Δ | Δ | Δ | Δ | Δ | Δ |
| After 360 days | Limiting resolution (µm) | × | 300 | 300 | × | × | 300 | × | × |
| | Pattern profile | × | Δ | Δ | × | × | Δ | × | × |
| Copper electromigration test (shorting time, hr) | | 100 | 300 | 300 | 100 | 100 | 100 | 100 | 100 |
| Dielectric breakdown strength (V/µm) | | 350 | 360 | 370 | 350 | 360 | 360 | 360 | 380 |
| Reliability | Adhesion | × | × | × | × | × | × | × | × |
| | Crack resistance | × | × | × | × | × | × | × | × |
| Presence/Absence of bonding defect induction | | yes | yes | yes | yes | yes | yes | yes | yes |
| Solvent resistance | | × | × | × | × | × | × | × | × |
| Relative permittivity | | 3.4 | 3.3 | 3.3 | 3.4 | 3.4 | 3.4 | 3.5 | 3.5 |
| Dielectric loss tangent (×10⁻²) | | 2.7 | 3.1 | 3.1 | 3.0 | 2.8 | 2.9 | 3.2 | 3.1 |

As is apparent from the above results, the inventive photosensitive resin compositions and photosensitive dry films have a good storage stability and enable fine pattern formation to be easily carried out with a thick film, therefore exhibiting satisfactory properties as photosensitive materials. Also, photosensitive resin films obtained from these have a high resistance to chemicals such as photoresist strippers and possess excellent adhesion, electrical insulating properties and copper electromigration resistance. These qualities endow them with a high reliability as dielectric protective films, enabling them to be advantageously used as materials for the formation of protective films for various types of electrical and electronic components, including circuit substrates, semiconductor devices and display devices. This invention thus makes it possible to provide higher reliability photosensitive resin compositions and photosensitive dry films.

## Claims

1. A photosensitive resin composition comprising:
(A) an epoxy group and/or phenolic hydroxyl group-containing silicone resin,
(B) a photoacid generator of formula (B) below 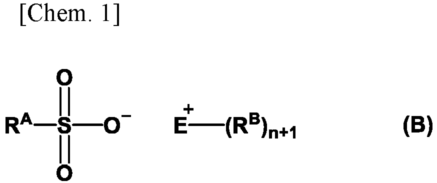 (wherein R^{A} is a hydrocarbyl group of 1 to 12 carbon atoms, some or all of the hydrogen atoms on which may be substituted with fluorine atoms,
each R^{B} is independently a monovalent organic group and two or more R^{B} groups may be bonded to each other directly or through -O-, -S-, -SO-, -SO₂-, -NH-, -CO-, COO-, -CONH-, a saturated hydrocarbylene group of 1 to 20 carbon atoms or a phenylene group to form a cyclic structure that includes an element E,
E is an element belonging to Groups 15 to 17 of the periodical table and having a valence n, and
n is an integer from 1 to 3), and
(C) a benzotriazole compound.

2. The photosensitive resin composition of claim 1, wherein the silicone resin (A) is represented by formula (A) below 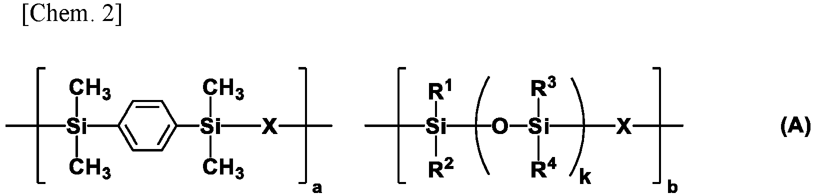 (wherein R¹ to R⁴ are each independently a hydrocarbyl group of 1 to 8 carbon atoms, k is an integer from 1 to 600, a and b are numbers which indicate the compositional ratios (molar ratios) of the respective recurring units and satisfy the conditions 0 < a < 1, 0 < b < 1 and a+b = 1; and X is an epoxy group and/or phenolic hydroxyl group-containing divalent organic group).

3. The photosensitive resin composition of claim 2, wherein the silicone resin (A) includes recurring units of formulas (a1) to (a4) and (b1) to (b4) below 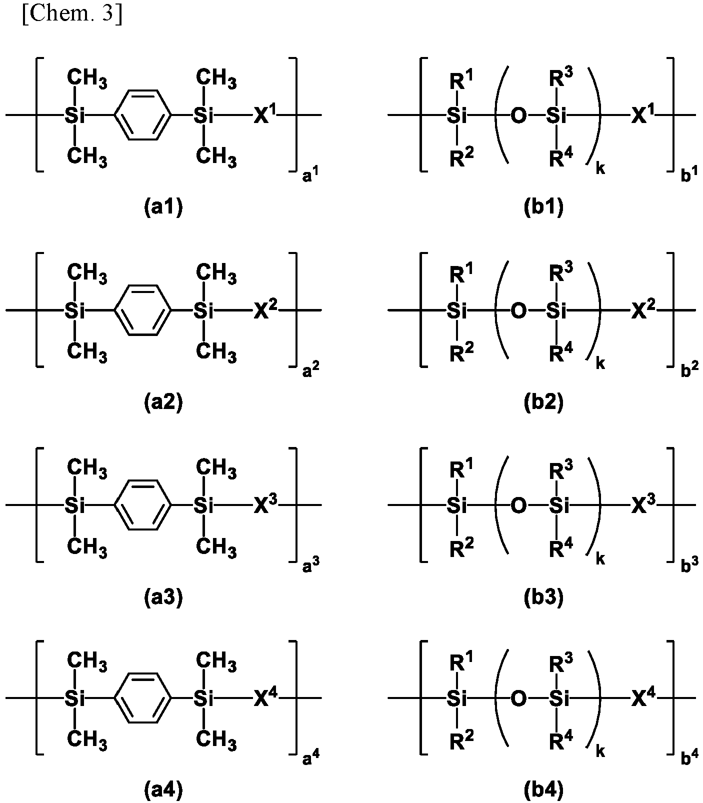 [wherein R¹ to R⁴ are each independently a hydrocarbyl group of 1 to 8 carbon atoms; k is an integer from 1 to 600; a¹ to a⁴ and b¹ to b⁴ are numbers which indicate the compositional ratios (molar ratios) of the respective recurring units and satisfy the conditions 0 ≤ a¹ < 1, 0 ≤ a² < 1,0 ≤ a³ < 1, 0 ≤ a⁴ < 1, 0 ≤ b¹ < 1, 0 ≤ b² < 1,0 ≤ b³ < 1, 0 ≤ b⁴ < 1,0 < a¹+a²+a³ < 1,0 < b¹+b²+b³ < 1 and a¹+a²+a³+a⁴+b¹+b²+b³+b⁴ = 1; X¹ is a divalent group of formula (X1) below 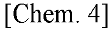 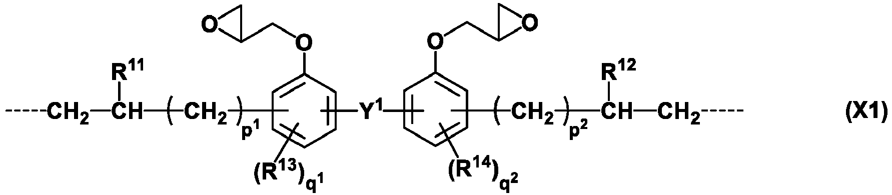 (wherein Y¹ is a single bond, a methylene group, a propane-2,2-diyl group, a 1,1,1,3,3,3-hexafluoropropane-2,2-diyl group or a fluorene-9,9-diyl group; R¹¹ and R¹² are each independently a hydrogen atom or a methyl group; R¹³ and R¹⁴ are each independently a saturated hydrocarbyl group of 1 to 4 carbon atoms or a saturated hydrocarbyloxy group of 1 to 4 carbon atoms; p¹ and p² are each independently an integer from 0 to 7; q¹ and q² are each independently an integer from 0 to 2; and the dashed lines are bonding sites); X² is a divalent group of formula (X2) below 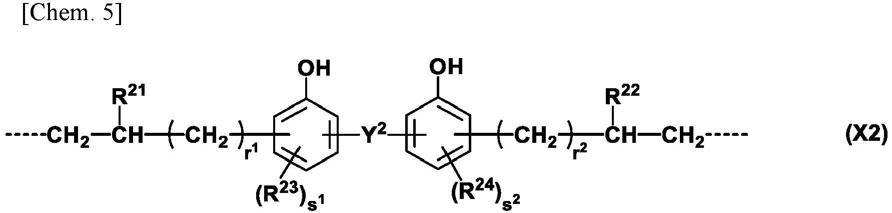 (wherein Y² is a single bond, a methylene group, a propane-2,2-diyl group, a 1,1,1,3,3,3-hexafluoropropane-2,2-diyl group or a fluorene-9,9-diyl group; R²¹ and R²² are each independently a hydrogen atom or a methyl group; R²³ and R²⁴ are each independently a saturated hydrocarbyl group of 1 to 4 carbon atoms or a saturated hydrocarbyloxy group of 1 to 4 carbon atoms; r¹ and r² are each independently an integer from 0 to 7; s¹ and s² are each independently an integer from 0 to 2; and the dashed lines are bonding sites); X³ is a divalent group of formula (X3) below 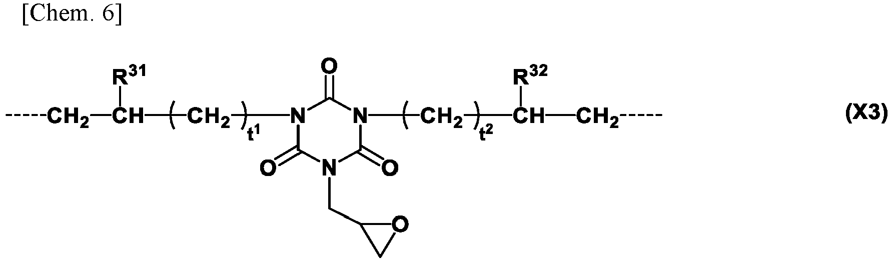 (wherein R³¹ and R³² are each independently a hydrogen atom or a methyl group; t¹ and t² are each independently an integer from 0 to 7; and the dashed lines are bonding sites); and X⁴ is a divalent group of formula (X4) below 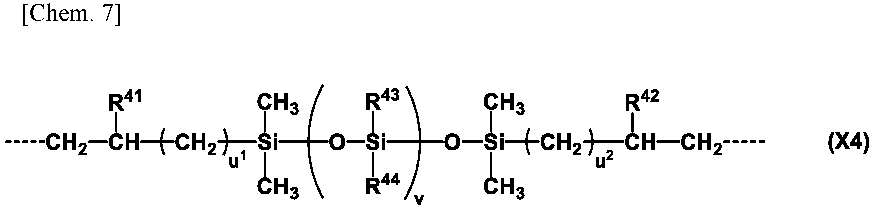 (wherein R⁴¹ and R⁴² are each independently a hydrogen atom or a methyl group; R⁴³ and R⁴⁴ are each independently a hydrocarbyl group of 1 to 8 carbon atoms; u¹ and u² are each independently an integer from 0 to 7; v is an integer from 0 to 600; and the dashed lines are bonding sites)].

4. The photosensitive resin composition of any one of claims 1 to 3, wherein E is a sulfur atom, and n is 2.

5. The photosensitive resin composition of any one of claims 1 to 4, further comprising (D) a crosslinking agent.

6. The photosensitive resin composition of claim 5, wherein the crosslinking agent (D) is at least one compound selected from the group consisting of nitrogen-containing compounds selected from melamine compounds, guanamine compounds, glycoluril compounds and urea compounds containing on average two or more methylol groups and/or alkoxymethyl groups per molecule; amino condensation products modified with formaldehyde or formaldehyde-alcohol; phenolic compounds containing on average two or more methylol groups or alkoxymethyl groups per molecule; and epoxy compounds containing on average two or more epoxy groups per molecule.

7. The photosensitive resin composition of any one of claims 1 to 6, further comprising (E) a solvent.

8. A photosensitive resin film obtained from the photosensitive resin composition of any one of claims 1 to 7.

9. A photosensitive dry film comprising a support film and, on the support film, the photosensitive resin film of claim 8.

10. A patterning process comprising the steps of:
(i) forming a photosensitive resin film on a substrate using the photosensitive resin composition of any one of claims 1 to 7,
(ii) exposing the photosensitive resin film to light, and
(iii) patterning the exposed photosensitive resin film by development with a developer.

11. A patterning process comprising the steps of:
(i') forming a photosensitive resin film on a substrate using the photosensitive dry film of claim 9,
(ii) exposing the photosensitive resin film to light, and
(iii) patterning the exposed photosensitive resin film by development with a developer.

12. The patterning method of claim 10 or 11, further comprising the step of:
(iv) post-curing at a temperature of between 100°C and 250°C the photosensitive resin film patterned by development.

13. The photosensitive resin composition of any one of claims 1 to 7 which is a film material for protecting electrical/electronic components.

14. The photosensitive resin composition of any one of claims 1 to 7 which is a substrate bonding film material for adhesively bonding two substrates.
